# EUROPEAN PATENT APPLICATION

(11) **EP 3 493 286 A1**
(43) Date of publication of application: **05.06.2019**
(21) Application number: 17834383.6
(22) Date of filing: 26.07.2017
(51) Int. Cl.: H01L 51/50, G02F 1/13357, H01L 27/32, H05B 33/02

(54) **ORGANIC ELECTRONIC MATERIAL**

(30) Priority: 26.07.2016 WO PCT/JP2016/071849; 29.07.2016 JP 2016150309
(71) Applicant: Hitachi Chemical Company, Ltd., Chiyoda-ku Tokyo 100-6606 (JP)
(72) Inventor: ISHITSUKA Kenichi, Tokyo 100-6606 (JP); SUGIOKA Tomotsugu, Tokyo 100-6606 (JP); YOSHINARI Yuki, Tokyo 100-6606 (JP); RYUZAKI Daisuke, Tokyo 100-6606 (JP); HONNA Ryo, Tokyo 100-6606 (JP)
(74) Representative: Beckmann, Claus
(86) International application number: PCT/JP2017/026971
(87) International publication number: WO 2018/021381

(57) **Abstract**

An organic electronic material containing a charge transport polymer that includes a 9-phenylcarbazole moiety, and also includes a structure branched in at least three directions from the 9-phenylcarbazole moiety, wherein the organic electronic material satisfies at least one of (I) or (II) below. (I) The 9-phenylcarbazole moiety has a hydrogen atom at position 4 of the phenyl group of the 9-phenylcarbazole moiety. (II) The charge transport polymer also has a triphenylamine structure in which at least one phenyl group has an alkoxy group.

## Description

### TECHNICAL FIELD

Embodiments of the present invention relate to an organic electronic material, and an organic layer that uses the material. Further, other embodiments of the present invention relate to an organic electronic element, an organic electroluminescent element (also called an "organic EL element"), a display element, an illumination device and a display device containing the above organic layer.

### BACKGROUND ART

Organic electronic elements are elements which use an organic substance to perform an electrical operation, and it is anticipated that such organic electronic elements will be capable of providing advantages such as lower energy consumption, lower prices and greater flexibility. Accordingly, organic electronic elements are attracting much attention as a potential alternative technology to conventional inorganic semiconductors containing mainly silicon.

Examples of organic electronic elements include organic electroluminescent elements (hereafter also referred to as "organic EL elements"), organic photoelectric conversion elements, and organic transistors.

Among the various organic electronic elements, organic EL elements are attracting attention for potential use in large-surface area solid state lighting applications to replace incandescent lamps or gas-filled lamps. Further, organic EL elements are also attracting attention as the leading self-luminous display for replacing liquid crystal displays (LCD) in the field of flat panel displays (FPD), and commercial products are becoming increasingly available.

Depending on the organic materials used, organic EL elements are broadly classified into low-molecular weight type organic EL elements and polymer type organic EL elements. In polymer type organic EL elements, a polymer compound is used as the organic material, whereas in low molecular weight type organic EL elements, a low-molecular weight compound is used. On the other hand, the production methods for organic EL elements are broadly classified into dry processes in which film formation is mainly performed in a vacuum system, and wet processes in which film formation is performed by plate-based printing such as relief printing or intaglio printing, or by plateless printing such as inkjet printing. Because wet processes enable simple film formation, they are expected to be an indispensable method in the production of future large-screen organic EL displays.

Accordingly, much development of materials suitable for wet processes is being pursued, and for example, investigations are being undertaken into the formation of multilayer structures using compounds having polymerizable groups (for example, see Patent Document 1 and Non-Patent Document 1).

### PRIOR ART DOCUMENTS

### PATENT DOCUMENT

Patent Document 1: JP 2006-279007 A

### NON-PATENT DOCUMENT

Non-Patent Document 1: Kengo Hirose, Daisuke Kumaki, Nobuaki Koike, Akira Kuriyama, Seiichiro Ikehata, and Shizuo Tokito, 53rd Meeting of the Japan Society of Applied Physics and Related Societies, 26p-ZK-4 (2006)

### SUMMARY OF THE INVENTION

### PROBLEMS TO BE SOLVED BY THE INVENTION

An organic EL element produced using wet processes has the advantages of facilitating cost reductions and increases in the element surface area. However, further improvements in the characteristics of the organic EL element would be desirable.

One embodiment of the present invention has been developed in light of the above circumstances, and has the object of providing an organic electronic material capable of producing an organic electronic element with various excellent characteristics such as superior lifespan characteristics. Further, other embodiments of the present invention have the objects of providing an organic layer formed using the organic electronic material, an organic electronic element and an organic EL element containing the organic layer, and a display element, an illumination device and a display device that use the organic EL element.

### MEANS TO SOLVE THE PROBLEMS

As a result of intensive investigation, the inventors of the present invention discovered that an organic electronic material containing a charge transport polymer that includes a 9-phenylcarbazole moiety and also includes a structure branched in at least three directions from the 9-phenylcarbazole moiety was capable of improving the emission efficiency and the lifespan characteristics of an organic EL element, and they were thus able to complete the present invention.

In other words, embodiments of the present invention include an organic electronic material, an organic layer, an organic electronic element, an organic EL element, a display element, an illumination device and a display device described below. However, the present invention is not limited to the following embodiments, and includes all manner of embodiments.

One embodiment relates to an organic electronic material containing a charge transport polymer that includes a 9-phenylcarbazole moiety, and also includes a structure branched in at least three directions from the 9-phenylcarbazole moiety, wherein the organic electronic material satisfies at least one of (I) or (II) shown below.
(I) The 9-phenylcarbazole moiety has a hydrogen atom at position 4 of the phenyl group of the 9-phenylcarbazole moiety.
(II) The charge transport polymer also has a triphenylamine structure in which at least one phenyl group has an alkoxy group.

In the above embodiment, the organic electronic material preferably also contains a dopant.

In the above embodiment, the dopant preferably contains an onium salt.

In the above embodiment, the charge transport polymer preferably has a polymerizable functional group.

Another embodiment relates to an organic layer formed using the organic electronic material of the embodiment described above.

Another embodiment relates to an organic electronic element containing the organic layer of the embodiment described above.

Another embodiment relates to an organic electroluminescent element containing the organic layer of the embodiment described above.

In the above embodiment, the organic layer is preferably a hole injection layer.

In the above embodiment, the organic layer is preferably a hole transport layer.

In the above embodiment, the organic electroluminescent element preferably also has a flexible substrate.

In the above embodiment, the organic electroluminescent element preferably also has a resin film substrate.

Another embodiment relates to a display element containing the organic electroluminescent element of the embodiment described above.

Another embodiment relates to an illumination device containing the organic electroluminescent element of the embodiment described above.

Yet another embodiment relates to a display device containing the illumination device of the embodiment described above, and a liquid crystal element as a display unit.

### EFFECTS OF THE INVENTION

One embodiment of the present invention is able to provide an organic electronic material capable of producing an organic electronic element having excellent lifespan characteristics. Other embodiments of the present invention are able to provide an organic thin film (organic layer) formed using the organic electronic material, an organic electronic element and an organic EL element containing the organic thin film, and a display element, an illumination device and a display device that use the organic EL element.

The disclosure of the present application is related to the subject matter disclosed in prior Japanese Application 2016-150309 and PCT/JP2016/071849, the entire contents of which are incorporated by reference herein.

### BRIEF DESCRIPTION OF THE DRAWINGS

FIG. 1 is a schematic view illustrating one example of an organic EL element of one embodiment.
FIG. 2 is a schematic view illustrating one example of an organic EL element of one embodiment.
FIG. 3 is a graph of the voltage-current density curve when a voltage is applied to each of the hole-only devices obtained in Examples 1B to 4B and Comparative Examples 1B to 4B.

### EMBODIMENTS FOR CARRYING OUT THE INVENTION

Embodiments of the present invention are described below in detail, but the present invention is not limited to the following embodiments.

### <Organic Electronic Material>

In one embodiment, an organic electronic material contains at least one charge transport polymer that has the ability to transport an electric charge. The organic electronic material contains at least a charge transport polymer having a structure branched in at least three directions, and the polymer includes a 9-phenylcarbazole moiety and has a structure branched in at least three directions from the 9-phenylcarbazole moiety, wherein (I) the 9-phenylcarbazole moiety has a hydrogen atom at position 4 of the phenyl group of the 9-phenylcarbazole moiety, and/or (II) the charge transport polymer also has a triphenylamine structure in which at least one phenyl group has an alkoxy group.

By producing an organic electronic material using at least one charge transport polymer of the above embodiment, various element characteristics including the emission lifespan can be easily improved. The organic electronic material may contain two or more types of the charge transport polymer of the above embodiment, and may also contain one or more other charge transport polymers.

### [Charge Transport Polymer]

In one embodiment, the organic electronic material contains a charge transport polymer that includes a 9-phenylcarbazole moiety, has a hydrogen atom at position 4 of the phenyl group of the 9-phenylcarbazole moiety, and also includes a structure branched in at least three directions from the 9-phenylcarbazole moiety. This charge transport polymer has the ability to transport an electric charge.

In another embodiment, the organic electronic material contains at least a charge transport polymer having a structure branched in at least three directions, wherein the polymer includes a trivalent or higher valent structural unit having a 9-phenylcarbazole structure (moiety), and a structural unit having a triphenylamine structure in which at least one of the phenyl groups bonded to the nitrogen atom has an alkoxy group.

The charge transport polymer preferably includes a divalent structural unit L having charge transport properties, a monovalent structural unit T that constitutes the terminal portions, and a trivalent or higher valent structural unit B that constitutes the branched portion. The charge transport polymer may contain only one type of each of these structural units, or may contain a plurality of types of each structural unit.

In the charge transport polymer, the various structural units are bonded together at "monovalent" to "trivalent or higher valent" bonding sites.

Any charge transport polymers (other charge transport polymers) besides the specified charge transport polymer of the above embodiment may be linear, or may have a branched structure. These other charge transport polymers preferably include at least a divalent structural unit L having charge transport properties, and a monovalent structural unit T that constitutes the terminal portions, and may also include a trivalent or higher valent structural unit B that constitutes a branched portion.

### (Structure)

Examples of the partial structures contained in the charge transport polymer include those shown below. However, the charge transport polymer is not limited to polymers having the following partial structures. In the partial structures, "L" represents a structural unit L, "T" represents a structural unit T, and "B" represents a structural unit B. The symbol "*" denotes a bonding site for bonding to another structural unit. In the following partial structures, the plurality of L structural units may be units having the same structure or units having mutually different structures. This also applies for the T and B units.

### Structural Examples of Charge Transport Polymer

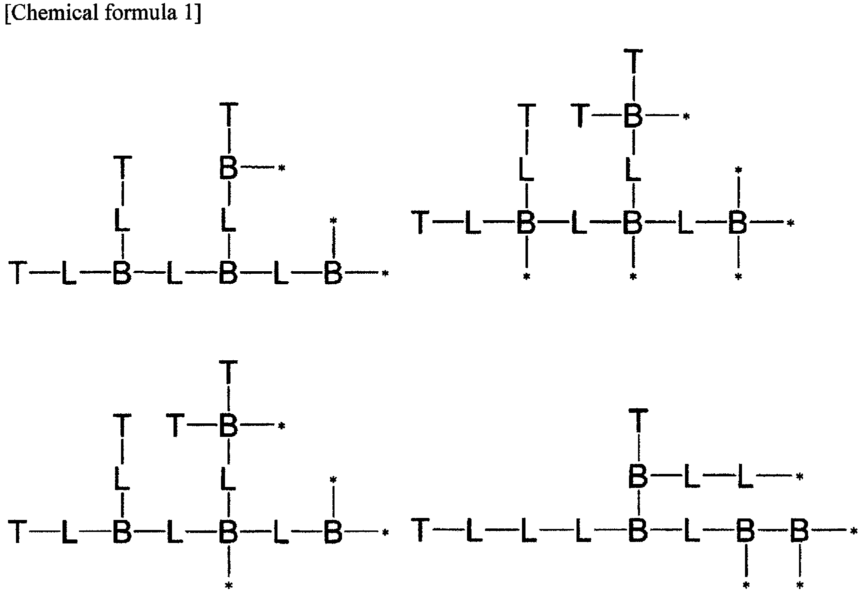

In one embodiment, the charge transport polymer includes at least a trivalent or higher valent structural unit B containing a trivalent or higher valent structural unit (1) having a 9-phenylcarbazole structure (moiety), and a monovalent structural unit T that constitutes the terminal portions, and may also include a divalent structural unit L having charge transport properties. In one embodiment, the charge transport polymer includes at least the trivalent or higher valent structural unit B containing the above structural unit (1), a divalent structural unit L, and a monovalent structural unit T. In this embodiment, the structural unit (1) preferably has a hydrogen atom at position 4 of the phenyl group of the 9-phenylcarbazole moiety. In another embodiment, in addition to the above structural unit (1), at least one structural unit B, L or T preferably contains a structural unit (2) having a triphenylamine structure. This structural unit (2) is preferably included in at least one structural unit L or T.

Each of the structural units is described below in further detail.

### (Structural Unit B)

The structural unit B is a trivalent or higher valent structural unit that constitutes a branched portion. From the viewpoint of improving the durability of the organic electronic element, the structural unit B is preferably not higher than hexavalent, and is more preferably either trivalent or tetravalent. The structural unit B is preferably a unit that has charge transport properties. For example, from the viewpoint of improving the durability of the organic electronic element, the structural unit B is preferably selected from among substituted or unsubstituted structures including aromatic amine structures, carbazole structures, condensed polycyclic aromatic hydrocarbon structures, and structures containing one, or two or more, of these structures.

Specific examples of the structural unit B are shown below. However, the structural unit B is not limited to the following structures.

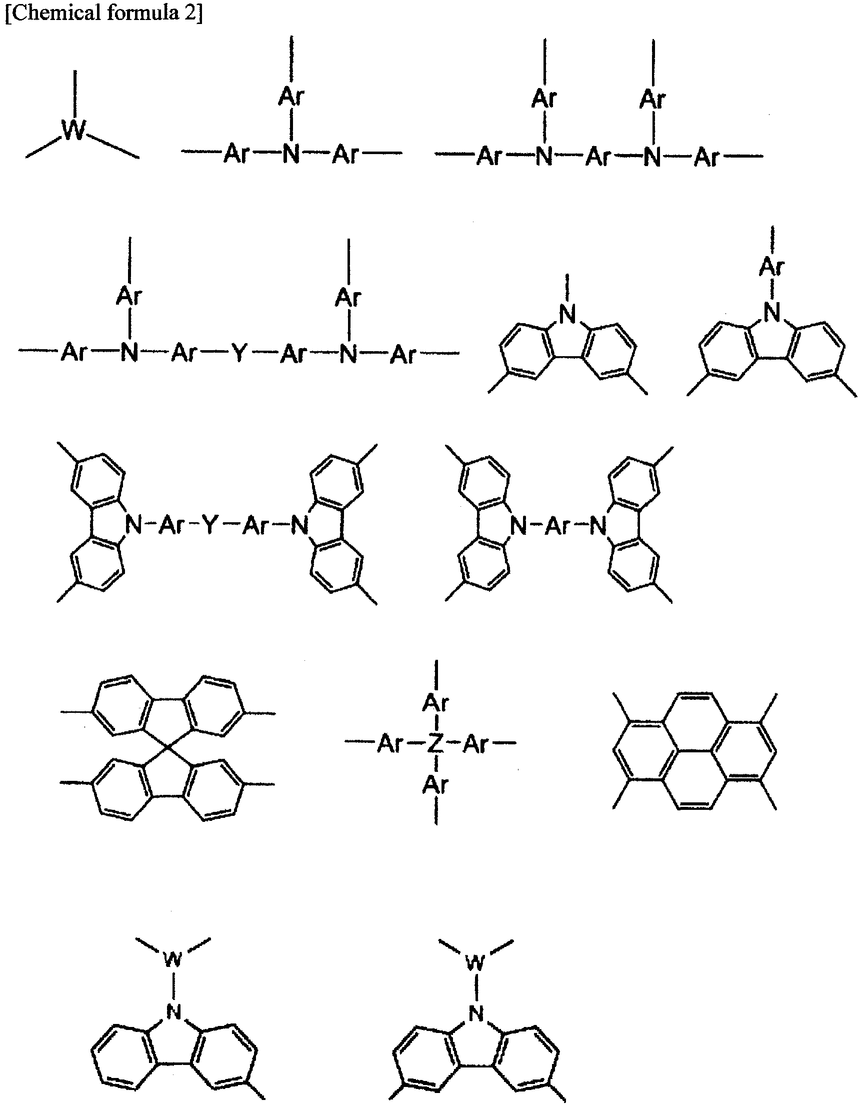

W represents a trivalent linking group, and for example, represents an arenetriyl group or heteroarenetriyl group of 2 to 30 carbon atoms. An arenetriyl group is an atom grouping in which three hydrogen atoms have been removed from an aromatic hydrocarbon. A heteroarenetriyl is an atom grouping in which three hydrogen atoms have been removed from an aromatic heterocycle. Each Ar independently represents a divalent linking group, and for example, may represent an arylene group or heteroarylene group of 2 to 30 carbon atoms. Ar preferably represents an arylene group, and more preferably a phenylene group. Y represents a divalent linking group, and examples include divalent groups in which an additional hydrogen atom has been removed from any of the R groups having one or more hydrogen atoms (but excluding groups containing a polymerizable functional group) in the structural unit L. Z represents a carbon atom, a silicon atom or a phosphorus atom.

In the above structural units, the benzene rings and Ar groups may have one or more substituents R. Each substituent R is independently selected from the group consisting of -R¹, -OR²,-SR³, -OCOR⁴, -COOR⁵, -SiR⁶R⁷R⁸, halogen atoms, and groups containing a polymerizable functional group described below. Each of R¹ to R⁸ independently represents a hydrogen atom, a linear, cyclic or branched alkyl group of 1 to 22 carbon atoms, or an aryl group or heteroaryl group of 2 to 30 carbon atoms (but excluding the case where R¹ represents a hydrogen atom).

An aryl group is an atom grouping in which one hydrogen atom has been removed from an aromatic hydrocarbon. A heteroaryl group is an atom grouping in which one hydrogen atom has been removed from an aromatic heterocycle. The alkyl group may be further substituted with an aryl group or heteroaryl group of 2 to 20 carbon atoms, and the aryl group or heteroaryl group may be further substituted with a linear, cyclic or branched alkyl group of 1 to 22 carbon atoms.

R is preferably an alkyl group, an aryl group, or an alkyl-substituted aryl group.

Examples of the aromatic hydrocarbon include monocyclic hydrocarbons, condensed ring hydrocarbons, and polycyclic hydrocarbons in which two or more hydrocarbons selected from among monocyclic hydrocarbons and condensed ring hydrocarbons are bonded together via single bonds. Examples of the aromatic heterocycles include monocyclic heterocycles, condensed ring heterocycles, and polycyclic heterocycles in which two or more heterocycles selected from among monocyclic heterocycles and condensed ring heterocycles are bonded together via single bonds.

### (Structural Unit B1)

The charge transport polymer used in the organic electronic material according to an embodiment of the present invention may arbitrarily include any of the trivalent or higher valent structural units B described above that constitute a branched portion, but must include at least a trivalent or higher valent structural unit (1) having a 9-phenylcarbazole structure (moiety). In the following description, this trivalent or higher valent structural unit (1) is also referred to as the structural unit B1.

The 9-phenylcarbazole structure refers to a structure in which the hydrogen atom on the nitrogen atom of 9H-carbazole has been substituted with a phenyl group. Accordingly, the above structural unit B1 means a structure having this 9-phenylcarbazole structure, and also having three or more linking groups capable of bonding to other structures. The phenyl group bonded to the nitrogen atom may have a substituent or a linking group, and substituents may be linked together to form a cyclic structure. Further, the aromatic rings that form the carbazole structure may also have a substituent or a linking group.

When the charge transport polymer includes, within the polymer molecule, a trivalent or higher valent structural unit B1 having a 9-phenylcarbazole structure, the emission lifespan and the emission efficiency of an organic EL element can be easily improved. Although the reasons for the improvement remain unclear, it is thought to be due to that fact that a charge transport polymer containing the structural unit B1 within the molecule has a higher triplet state (T1) level, as shown in the examples described below. Further, it is thought that improving the emission efficiency yields an improvement in the emission lifespan of the organic EL element.

Specific examples of the structural unit B1 include the units shown below.

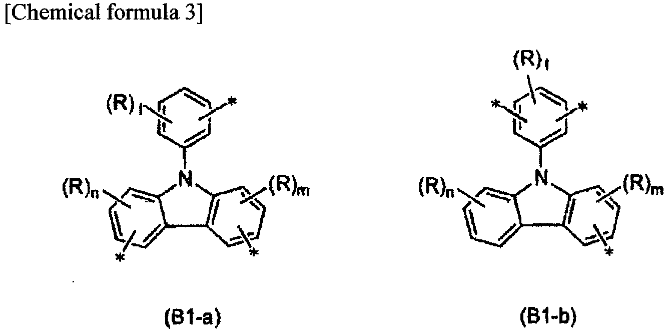

Specific examples of preferred forms of the structural unit B1 include the structural units shown below.

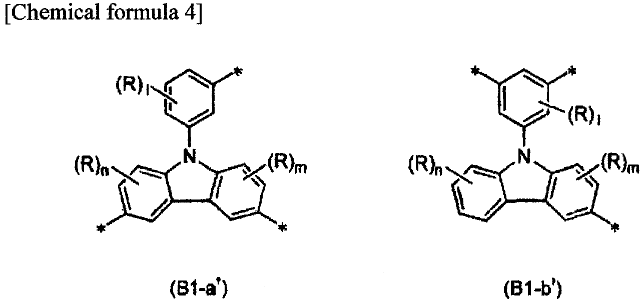

In the structural units (B1-a) and (B1-a') shown above, 1 represents an integer of 0 to 4, and each of m and n independently represents an integer of 0 to 3, with each value indicating a number of substituents R. In the structural units (B1-b) and (B1-b') shown above, each of 1 and m independently represents an integer of 0 to 3, and n represents an integer of 0 to 4, with each value indicating a number of substituents R. In each of the structural units, the symbol "*" denotes a bonding site to another structure.

Each substituent R is independently selected from the group consisting of -R¹, -OR², -SR³,-OCOR⁴, -COOR⁵, -SiR⁶R⁷R⁸, halogen atoms, and groups containing a polymerizable functional group described below. R¹ to R⁸ are as described above in relation to the structural unit B. In one embodiment, the substituent R in each of the above structural units is preferably a linear, cyclic or branched alkyl group of 1 to 12 carbon atoms, or an aryl group of 2 to 12 carbon atoms. The aryl group may be further substituted with a linear, cyclic or branched alkyl group of 1 to 12 carbon atoms.

In one embodiment of each of the above structural units, the value of l+m+n is preferably from 0 to 3, and is more preferably 0 or 1. Further, in one embodiment, the substituent R is more preferably selected from the group consisting of linear, cyclic or branched alkyl groups of 1 to 8 carbon atoms, and aryl groups of 2 to 8 carbon atoms.

Among the various forms of the structural unit B1 described above, a structure having a hydrogen atom at position 4 of the phenyl group of the 9-phenylcarbazole moiety is particularly preferred. In this type of structure, the phenyl group has a hydrogen atom at position 4, but may have a substituent or a linking group other than a hydrogen atom at the other positions of the 9-phenylcarbazole, and substituents may be linked together to form a cyclic structure. Examples of preferred substituents include the same substituents as those mentioned above for the case where R in the structural unit L represents a substituent. Examples of the linking group include divalent groups in which an additional hydrogen atom has been removed from any of the R groups having one or more hydrogen atoms (but excluding groups containing a polymerizable functional group) in the structural unit L. In the case of a structure having a hydrogen atom at position 4 of the phenyl group of the 9-phenylcarbazole moiety, the triplet state (T1) level increases, further facilitating improvement in the emission lifespan and the emission efficiency.

Specific examples of the above structure are shown below. However, the structural unit B1 is not limited to the following structures. In each structural unit, "*" denotes a bonding site to another structure.

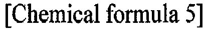

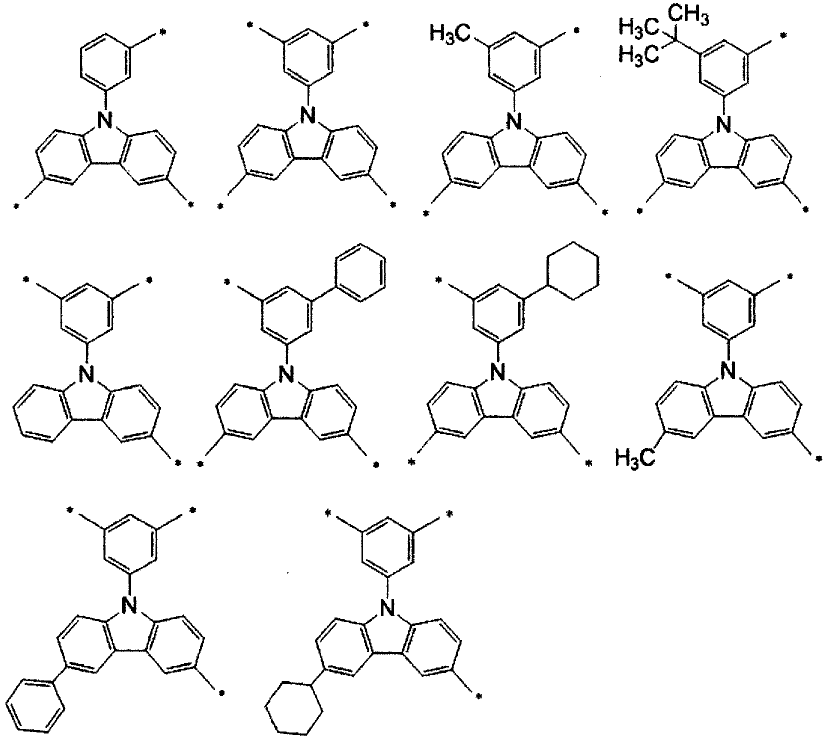

### (Structural Unit L)

The structural unit L is a divalent structural unit having charge transport properties. There are no particular limitations on the structural unit L, provided it includes an atom grouping having the ability to transport an electric charge. For example, the structural unit L may be selected from among substituted or unsubstituted structures including aromatic amine structures, carbazole structures, thiophene structures, fluorene structures, benzene structures, biphenyl structures, terphenyl structures, naphthalene structures, anthracene structures, tetracene structures, phenanthrene structures, dihydrophenanthrene structures, pyridine structures, pyrazine structures, quinoline structures, isoquinoline structures, quinoxaline structures, acridine structures, diazaphenanthrene structures, furan structures, pyrrole structures, oxazole structures, oxadiazole structures, thiazole structures, thiadiazole structures, triazole structures, benzothiophene structures, benzoxazole structures, benzoxadiazole structures, benzothiazole structures, benzothiadiazole structures, benzotriazole structures, and structures containing one, or two or more, of the above structures. The aromatic amine structures are preferably triarylamine structures, and more preferably triphenylamine structures.

In one embodiment, from the viewpoint of obtaining superior hole transport properties, the structural unit L is preferably selected from among substituted or unsubstituted structures including aromatic amine structures, carbazole structures, thiophene structures, fluorene structures, benzene structures, pyrrole structures, and structures containing one, or two or more, of these structures, and is more preferably selected from among substituted or unsubstituted structures including aromatic amine structures, carbazole structures, and structures containing one, or two or more, of these structures. In another embodiment, from the viewpoint of obtaining superior electron transport properties, the structural unit L is preferably selected from among substituted or unsubstituted structures including fluorene structures, benzene structures, phenanthrene structures, pyridine structures, quinoline structures, and structures containing one, or two or more, of these structures.

From the viewpoint of emission efficiency, the charge transport polymer preferably includes a carbazole (and more preferably a 9-phenylcarbazole) structure as a structural unit L.

Specific examples of the structural unit L are shown below, but the structural unit L is not limited to the following structures.

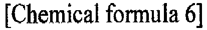

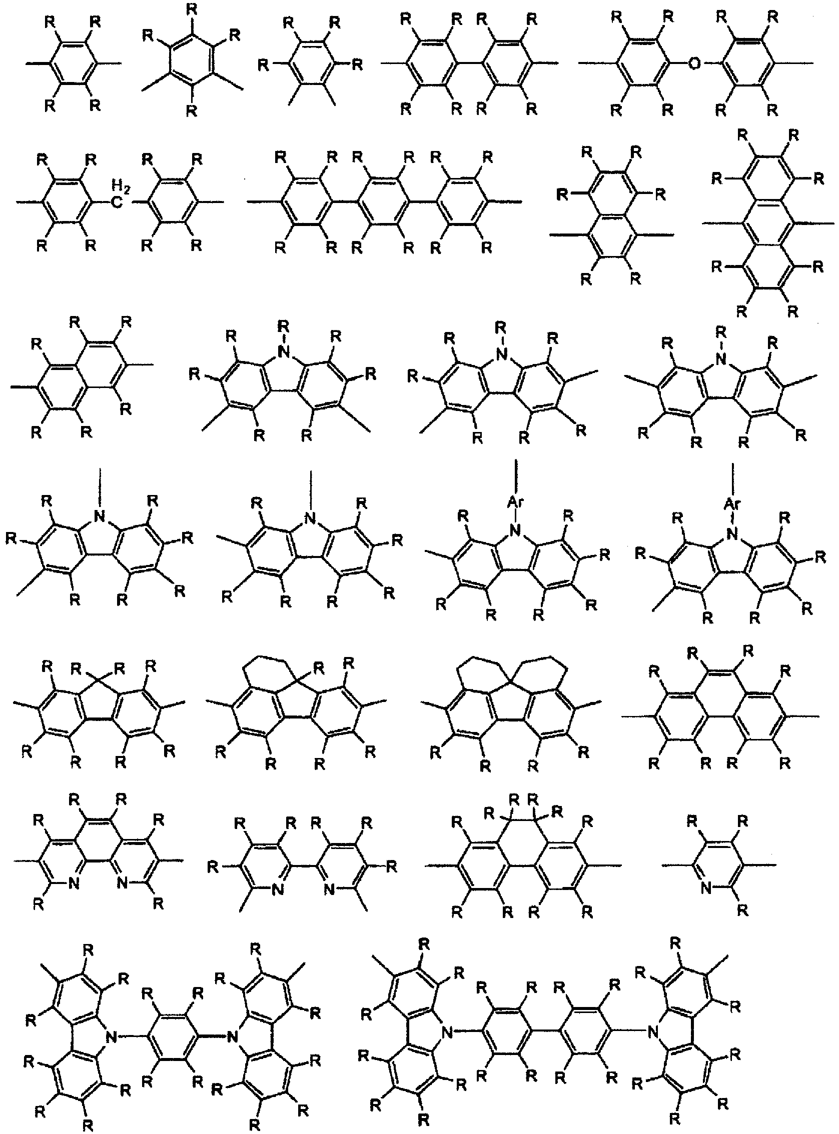

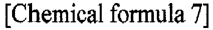

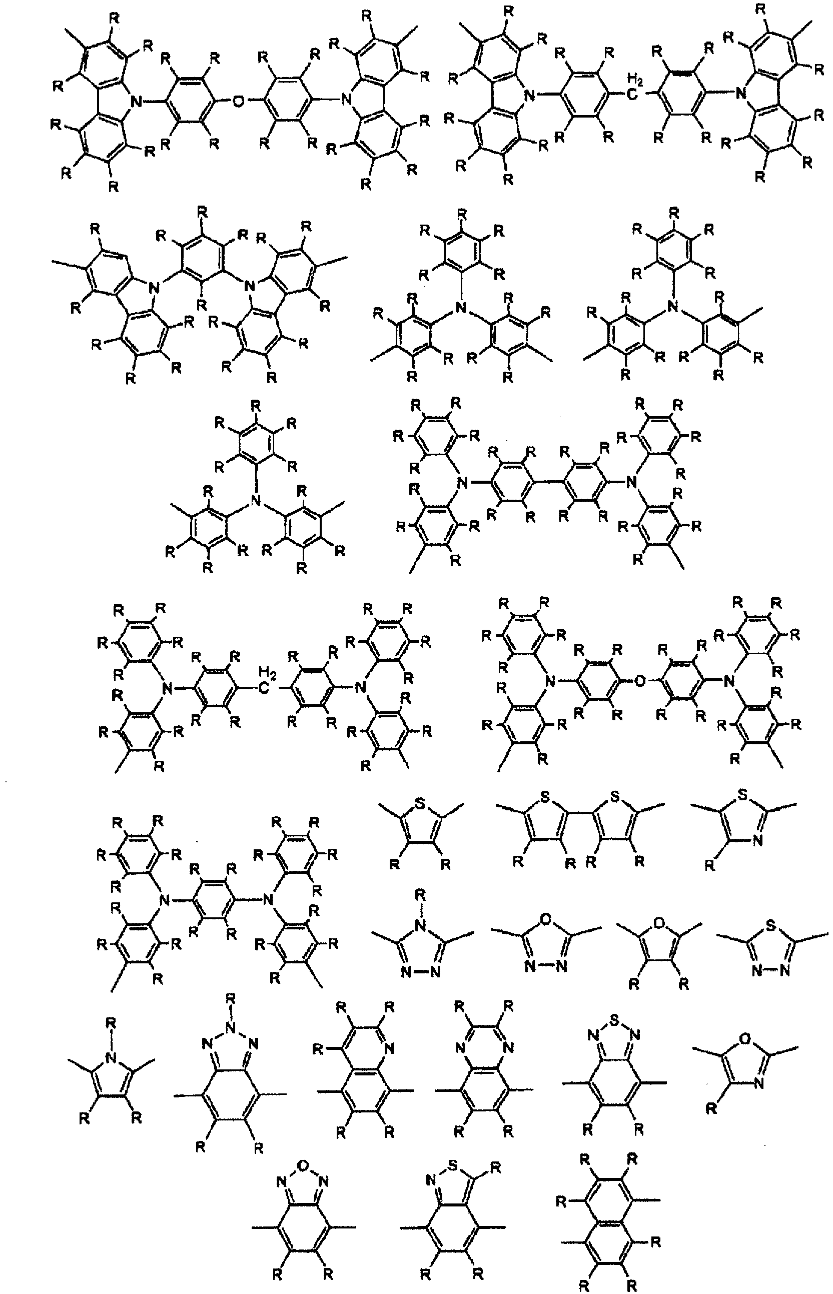

Each R independently represents a hydrogen atom or a substituent. Each R is preferably independently selected from the group consisting of -R¹, -OR², -SR³, -OCOR⁴, -COOR⁵, -SiR⁶R⁷R⁸, halogen atoms, and groups containing a polymerizable functional group described below. Each of R¹ to R⁸ independently represents a hydrogen atom, a linear, cyclic or branched alkyl group of 1 to 22 carbon atoms, or an aryl group or heteroaryl group of 2 to 30 carbon atoms. An aryl group is an atom grouping in which one hydrogen atom has been removed from an aromatic hydrocarbon. A heteroaryl group is an atom grouping in which one hydrogen atom has been removed from an aromatic heterocycle. The alkyl group may be further substituted with an aryl group or heteroaryl group of 2 to 20 carbon atoms, and the aryl group or heteroaryl group may be further substituted with a linear, cyclic or branched alkyl group of 1 to 22 carbon atoms. R is preferably a hydrogen atom, an alkyl group, an aryl group, or an alkyl-substituted aryl group. Ar represents an arylene group or heteroarylene group of 2 to 30 carbon atoms. An arylene group is an atom grouping in which two hydrogen atoms have been removed from an aromatic hydrocarbon. A heteroarylene group is an atom grouping in which two hydrogen atoms have been removed from an aromatic heterocycle. Ar is preferably an arylene group, and more preferably a phenylene group.

Examples of the aromatic hydrocarbon include monocyclic hydrocarbons, condensed ring hydrocarbons, and polycyclic hydrocarbons in which two or more hydrocarbons selected from among monocyclic hydrocarbons and condensed ring hydrocarbons are bonded together via single bonds. Examples of the aromatic heterocycles include monocyclic heterocycles, condensed ring heterocycles, and polycyclic heterocycles in which two or more heterocycles selected from among monocyclic heterocycles and condensed ring heterocycles are bonded together via single bonds.

### (Structural Unit LI)

The charge transport polymer used in the organic electronic material according to an embodiment of the present invention may arbitrarily include any of the divalent structural units L described above, but in one embodiment, preferably includes a divalent structural unit (2) having a triphenylamine structure in which at least one phenyl group has an alkoxy group. In the following description, this divalent structural unit (2) is also referred to as the structural unit L1.

In the structural unit L1, the above triphenylamine structure has a structure in which at least one of the phenyl groups bonded to the nitrogen atom has at least one alkoxy group. The phenyl group(s) may also have a substituent other than an alkoxy group, or a linking group, and substituents may be linked together to form a cyclic structure. In other words, the structural unit L1 means a structure in which two linking groups are bonded to the triphenylamine structure in which at least one phenyl group has an alkoxy group.

In order to improve various characteristics of the organic EL element, the charge transport polymer (polymer compound) preferably has excellent charge transport properties and excellent thermal stability. The thermal stability (heat resistance) of conventional charge transport polymers used in organic EL elements is often unsatisfactory. Accordingly, an organic thin film formed from a conventional charge transport polymer tends to degrade readily as a result of the heat generated during high-temperature processes or during operation of the organic EL element. Accompanying this type of heat resistance problem, from the viewpoint of the lifespan characteristics, an organic EL element that exhibits satisfactory characteristics has yet to be obtained, and further improvements would be desirable. In order to improve various characteristics of the organic EL element, the charge transport polymer preferably has excellent charge transport properties and excellent thermal stability.

In this regard, in those cases where the charge transport polymer includes the above structural unit L1 within the molecule, the emission lifespan of the organic EL element can be easily improved. Although the details remain unclear, in those cases where an alkoxy group is introduced into at least one of the phenyl groups in a triphenylamine structure, the heat resistance can be easily improved. As a result, it is thought that using a charge transport polymer that includes a structural unit having this type of specific triphenylamine structure contributes to an improvement in the emission lifespan of the organic EL element as a result of an improvement in the heat resistance of the polymer, enabling suppression of any degradation in the organic thin film.

Specific examples of the above structural unit L1 include the units shown below.

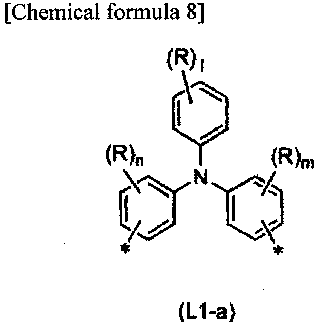

Specific examples of preferred forms of the structural unit L1 include the structural units shown below.

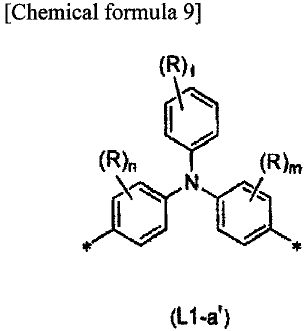

In the above structural units (L1-a) and (L1-a'), 1 represents an integer of 0 to 5, each of m and n independently represents an integer of 0 to 4, with each value indicating a number of substituents R. In the structural unit, "*" denotes a bonding site to another structure.

In the above structural units, l+n+m is 1 or greater, and at least one substituent R is an alkoxy group (-OR). The alkoxy group means a group in which an alkyl group of 1 to 8 carbon atoms is bonded to the oxygen atom. In one embodiment, the alkoxy group is preferably a group in which a linear or branched alkyl group of 1 to 8 carbon atoms is bonded to the oxygen atom.

In the above structural units, at least one of the phenyl groups bonded to the nitrogen atom may have a substituent R other than the above alkoxy group (-OR). This substituent R other than the above alkoxy group may be selected from the group consisting of -R¹, -OR², -SR³, -OCOR⁴, -COOR⁵, -SiR⁶R⁷R⁸, halogen atoms, and groups containing a polymerizable functional group described below. R¹ to R⁸ are as described above in relation to the structural unit B1. However, -OR² does not include the above alkoxy group (-OR).

More preferred examples of the structural unit L1 include the units shown below. However, the structural unit L1 is not limited to the following units. In each of the structural units, "*" denotes a bonding site to another structure.

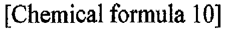

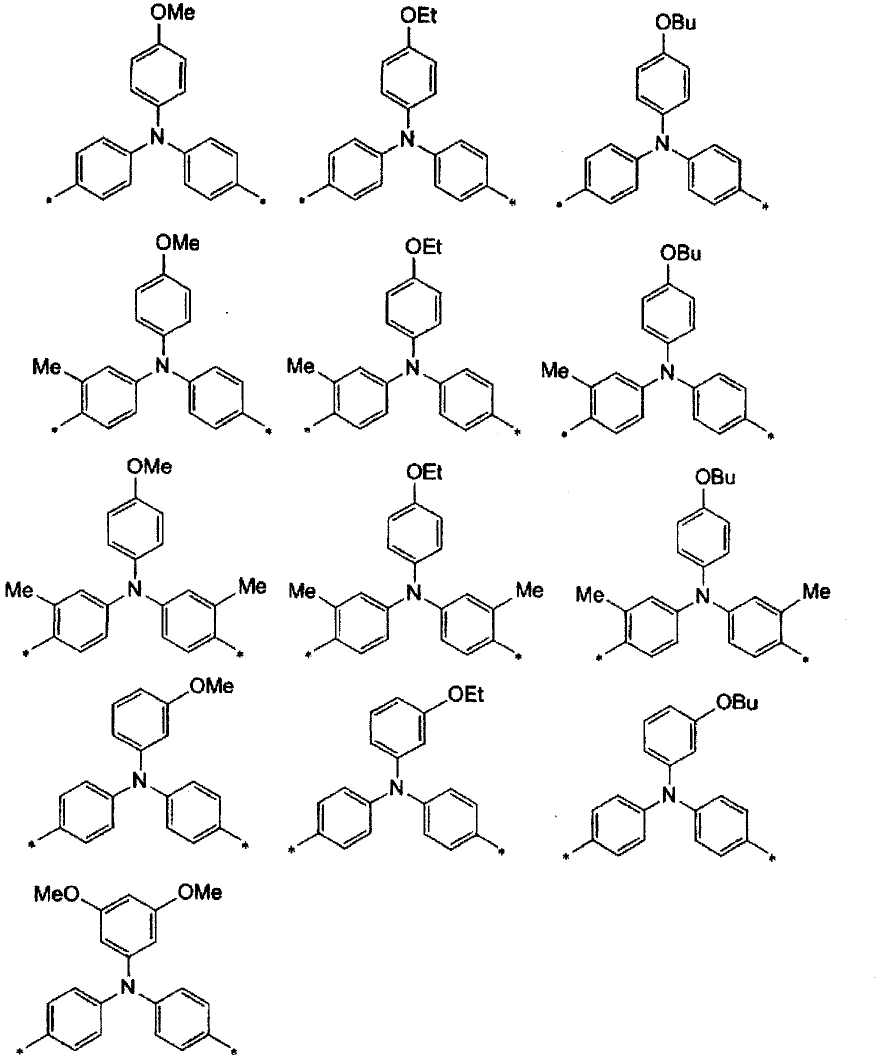

### (Structural Unit T)

The structural unit T is a monovalent structural unit that constitutes a terminal portion of the charge transport polymer. There are no particular limitations on the structural unit T, which may be selected from among substituted or unsubstituted structures including aromatic hydrocarbon structures, aromatic heterocyclic structures, and structures containing one, or two or more, of these structures. The structural unit T may have a similar structure to the structural unit L. In one embodiment, from the viewpoint of imparting durability to the polymer without impairing the charge transport properties, the structural unit T is preferably a substituted or unsubstituted aromatic hydrocarbon structure, and is more preferably a substituted or unsubstituted benzene structure. Further, in another embodiment, when the charge transport polymer has a polymerizable functional group at a terminal portion in the manner described below, the structural unit T may be a polymerizable structure (for example, a polymerizable functional group such as a pyrrolyl group).

Specific examples of the structural unit T include the units shown below. However, the structural unit T is not limited to the following structural units.

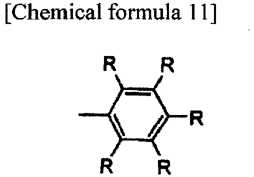

R is the same as R described in relation to the structural unit L. In those cases where the charge transport polymer has a polymerizable functional group at a terminal portion, it is preferable that at least one R is a group containing a polymerizable functional group.

### (Structural Unit T1)

The charge transport polymer used in the organic electronic material according to an embodiment of the present invention may arbitrarily include any of the monovalent structural units T described above, but in one embodiment, preferably includes a monovalent structural unit having a triphenylamine structure having at least one alkoxy group. In the following description, this monovalent structural unit is also referred to as the structural unit T1.

Specific examples of the structural unit T1 include the units shown below.

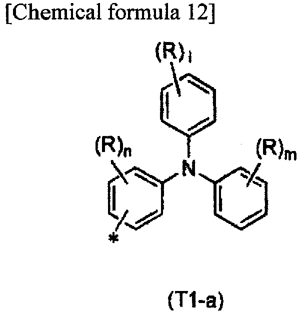

Specific examples of preferred forms of the structural unit T1 include the structural units shown below.

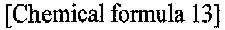

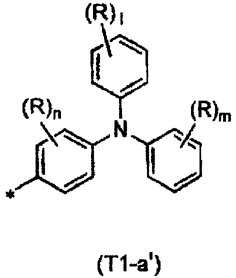

In the above structural units (T1-a) and (T1-a'), each of 1 and m independently represents an integer of 0 to 5, and n represents an integer of 0 to 4, with each value indicating a number of substituents R. Further, l+n+m is 1 or greater, and at least one substituent R is an alkoxy group (-OR). The alkoxy group is a group in which an alkyl group of 1 to 8 carbon atoms is bonded to the oxygen atom. In the above structural unit, at least one of the phenyl groups bonded to the nitrogen atom may have a substituent R other than the above alkoxy group. The alkoxy group (-OR) and the substituent R other than the alkoxy group are as described above in relation to the divalent structural unit L1. When the charge transport polymer includes the structural unit T1 within the molecule, excellent heat resistance is obtained, and therefore the emission lifespan of the organic EL element can be easily improved.

More preferred examples of the structural unit T1 include the units shown below. However, the structural unit T1 is not limited to the following units. In each of the structural units, "*" denotes a bonding site to another structure.

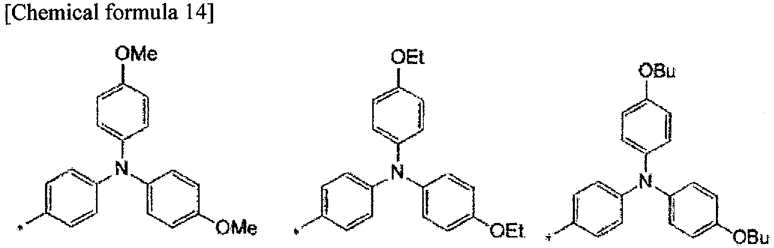

### (Group containing Polymerizable Functional Group)

In one embodiment, from the viewpoint of enabling the polymer to be cured by a polymerization reaction, thereby changing the solubility in solvents, the charge transport polymer preferably has at least one polymerizable functional group. A "polymerizable functional group" refers to a group which is able to form bonds upon the application of heat and/or light.

Examples of the polymerizable functional group include groups having a carbon-carbon multiple bond (such as a vinyl group, allyl group, butenyl group, ethynyl group, acryloyl group, acryloyloxy group, acryloylamino group, methacryloyl group, methacryloyloxy group, methacryloylamino group, vinyloxy group and vinylamino group), groups having a small ring (including cyclic alkyl groups such as a cyclopropyl group and cyclobutyl group; cyclic ether groups such as an epoxy group (oxiranyl group) and oxetane group (oxetanyl group); diketene groups; episulfide groups; lactone groups; and lactam groups); and heterocyclic groups (such as a furanyl group, pyrrolyl group, thiophenyl group and silolyl group). Particularly preferred polymerizable functional groups include a vinyl group, acryloyl group, methacryloyl group, epoxy group and oxetane group, and from the viewpoints of improving the reactivity and the characteristics of the organic electronic element, a vinyl group, oxetane group or epoxy group is even more preferred.

From the viewpoints of increasing the degree of freedom associated with the polymerizable functional group and facilitating the polymerization reaction, the main backbone of the charge transport polymer and the polymerizable functional group are preferably linked via an alkylene chain. Further, in the case where, for example, the organic layer is to be formed on an electrode, from the viewpoint of enhancing the affinity with hydrophilic electrodes of ITO or the like, the main backbone and the polymerizable functional group are preferably linked via a hydrophilic chain such as an ethylene glycol chain or a diethylene glycol chain. Moreover, from the viewpoint of simplifying preparation of the monomer used for introducing the polymerizable functional group, the charge transport polymer may have an ether linkage or an ester linkage at the terminal of the alkylene chain and/or the hydrophilic chain, namely, at the linkage site between these chains and the polymerizable functional group, and/or at the linkage site between these chains and the charge transport polymer backbone. The aforementioned "group containing a polymerizable functional group" means a polymerizable functional group itself, or a group composed of a combination of a polymerizable functional group and an alkylene chain or the like. Examples of groups that can be used favorably as this group containing a polymerizable functional group include the groups exemplified in WO 2010/140553.

The polymerizable functional group may be introduced at a terminal portion of the charge transport polymer (namely, a structural unit T), at a portion other than a terminal portion (namely, a structural unit L or B), or at both a terminal portion and a portion other than a terminal. From the viewpoint of the curability, the polymerizable functional group is preferably introduced at least at a terminal portion, and from the viewpoint of achieving a combination of favorable curability and charge transport properties, is preferably introduced only at terminal portions. Further, in those cases where the charge transport polymer has a branched structure, the polymerizable functional group may be introduced within the main chain of the charge transport polymer, within a side chain, or within both the main chain and a side chain.

From the viewpoint of contributing to a change in the solubility, the polymerizable functional group is preferably included in the charge transport polymer in a large amount. On the other hand, from the viewpoint of not impeding the charge transport properties, the amount included in the charge transport polymer is preferably kept small. The amount of the polymerizable functional group may be set as appropriate with due consideration of these factors.

For example, from the viewpoint of obtaining a satisfactory change in the solubility, the number of polymerizable functional groups per one molecule of the charge transport polymer is preferably at least 2, and more preferably 3 or greater. Further, from the viewpoint of maintaining good charge transport properties, the number of polymerizable functional groups is preferably not more than 1,000, and more preferably 500 or fewer.

The number of polymerizable functional groups per one molecule of the charge transport polymer can be determined as an average value from the amount of the polymerizable functional group used in synthesizing the charge transport polymer (for example, the amount added of the monomer having the polymerizable functional group), the amounts added of the monomers corresponding with the various structural units, and the weight average molecular weight of the charge transport polymer and the like. Further, the number of polymerizable functional groups can also be calculated as an average value using the ratio between the integral of the signal attributable to the polymerizable functional group and the integral of the total spectrum in the ¹H-NMR (nuclear magnetic resonance) spectrum of the charge transport polymer, and the weight average molecular weight of the charge transport polymer and the like. In terms of simplicity, if the amounts added of the various components are clear, then the number of polymerizable functional groups is preferably determined from these amounts.

In one embodiment, the charge transport polymer having a structure branched in at least three directions includes at least a trivalent or higher valent structural unit B 1 having a 9-phenylcarbazole structure as a trivalent or higher valent structural unit B, and also includes at least a structural unit L1 and/or T1 having a triphenylamine structure with at least one alkoxy group as a structural unit L and/or T.

Further, in another embodiment, the charge transport polymer includes the above structural unit B1, and at least the above structural unit L1 and/or T1 as a structural unit L and/or T.

Furthermore, in another embodiment, the charge transport polymer includes the above structural unit B1, and the aforementioned structural unit L and structural unit T, and includes at least the above structural unit T1 and a structural unit T having a polymerizable functional group as the above structural unit T.

In yet another embodiment, the charge transport polymer includes the above structural unit B1, and the aforementioned structural unit L and structural unit T, wherein at least one of the structural unit L and/or T contains a carbazole structure (and preferably a 9-phenylcarbazole structure).

In each of these embodiments, the structural unit B1 is preferably a structure having a hydrogen atom at position 4 of the phenyl group of the 9-phenylcarbazole structure.

According to one embodiment, by using a charge transport polymer that includes at least the structural unit B1, the structural unit L1 and/or the structural unit T1, improvements in the heat resistance and the emission lifespan of the organic EL element can be realized. From the viewpoint of obtaining these types of effects more effectively, the proportion of the structural unit B1, relative to the total mass of all the structural units B, is preferably at least 50 mol%, more preferably at least 60 mol%, and even more preferably 70 mol% or greater.

Further, in those cases where the charge transport polymer includes the structural unit L1, the proportion of the structural unit L1 relative to the total mass of all the structural units L is preferably at least 50 mol%, more preferably at least 60 mol%, and even more preferably 70 mol% or greater.

Moreover, in those cases where the charge transport polymer includes the structural unit T1 as a structural unit T, the proportion of the structural unit T1 relative to the total mass of all the structural units T is preferably at least 30 mol%, more preferably at least 40 mol%, and even more preferably 50 mol% or greater.

From the viewpoint of improving the heat resistance of the charge transport polymer, the proportion of the structural unit L1 and/or T1, relative to the total mass of all the structural units in the polymer, is preferably at least 10 mol%, more preferably at least 20 mol%, and even more preferably 30 mol% or greater. In those cases where the charge transport polymer includes both of the structural units L1 and T1, the above proportion refers to the total mass of L1 and T1.

### (Proportions of Structural Units)

From the viewpoint of ensuring satisfactory charge transport properties, the proportion of the structural unit L contained in the charge transport polymer, relative to the total of all the structural units, is preferably at least 10 mol%, more preferably at least 20 mol%, and even more preferably 30 mol% or greater. If the structural unit T and the structural unit B are taken into consideration, then the proportion of the structural unit L is preferably not more than 95 mol%, more preferably not more than 90 mol%, and even more preferably 85 mol% or less. In those cases where the charge transport polymer includes the structural unit L1, the above proportion refers to the total of all the structural units L including the structural unit L1.

From the viewpoint of improving the characteristics of the organic electronic element, or from the viewpoint of suppressing any increase in viscosity and enabling more favorable synthesis of the charge transport polymer, the proportion of the structural unit T contained in the charge transport polymer, relative to the total of all the structural units, is preferably at least 5 mol%, more preferably at least 10 mol%, and even more preferably 15 mol% or greater. Further, from the viewpoint of ensuring satisfactory charge transport properties, the proportion of the structural unit T is preferably not more than 60 mol%, more preferably not more than 55 mol%, and even more preferably 50 mol% or less. In those cases where the charge transport polymer includes the structural unit T1, the above proportion refers to the total of all the structural units T including the structural unit T1.

From the viewpoint of improving the durability of the organic electronic element, the proportion of the structural unit B contained in the charge transport polymer, relative to the total of all the structural units, is preferably at least 1 mol%, more preferably at least 5 mol%, and even more preferably 10 mol% or greater. Further, from the viewpoints of suppressing any increase in viscosity and enabling more favorable synthesis of the charge transport polymer, or from the viewpoint of ensuring satisfactory charge transport properties, the proportion of the structural unit B is preferably not more than 50 mol%, more preferably not more than 40 mol%, and even more preferably 30 mol% or less. The above proportion refers to the total mass of all the structural units B including the structural unit B1.

In those cases where the charge transport polymer has a polymerizable functional group, from the viewpoint of ensuring efficient curing of the charge transport polymer, the proportion of the polymerizable functional group, relative to the total of all the structural units, is preferably at least 0.1 mol%, more preferably at least 1 mol%, and even more preferably 3 mol% or greater. Further, from the viewpoint of ensuring favorable charge transport properties, the proportion of the polymerizable functional group is preferably not more than 70 mol%, more preferably not more than 60 mol%, and even more preferably 50 mol% or less. Here, the "proportion of the polymerizable functional group" refers to the proportion of structural units having the polymerizable functional group.

Considering the balance between the charge transport properties, the durability, and the productivity and the like, the ratio (molar ratio) between the structural unit L, the structural unit T and the structural unit B is preferably L:T:B = 100:(10 to 200):(10 to 100), more preferably 100:(20 to 180):(20 to 90), and even more preferably 100:(40 to 160):(30 to 80).

The proportion of each structural unit can be determined from the amount added of the monomer corresponding with the each structural unit that is used for synthesis of the charge transport polymer. Further, the proportion of each structural unit can also be calculated as an average value using the integral of the spectrum attributable to the structural unit in the ¹H-NMR spectrum of the charge transport polymer. In terms of simplicity, if the amount added of the monomer is clear, then the proportion of the structural unit preferably employs the value determined using the amount added of the monomer.

### (Number Average Molecular weight)

The number average molecular weight of the charge transport polymer can be adjusted appropriately with due consideration of the solubility in solvents and the film formability and the like. From the viewpoint of ensuring superior charge transport properties, the number average molecular weight is preferably at least 500, more preferably at least 1,000, and even more preferably 2,000 or greater. Further, from the viewpoints of maintaining favorable solubility in solvents and facilitating the preparation of ink compositions, the number average molecular weight is preferably not more than 1,000,000, more preferably not more than 100,000, and even more preferably 50,000 or less.

### (Weight Average Molecular Weight)

The weight average molecular weight of the charge transport polymer can be adjusted appropriately with due consideration of the solubility in solvents and the film formability and the like. From the viewpoint of ensuring superior charge transport properties, the weight average molecular weight is preferably at least 1,000, more preferably at least 5,000, and even more preferably 10,000 or greater. Further, from the viewpoints of maintaining favorable solubility in solvents and facilitating the preparation of ink compositions, the mass average molecular weight is preferably not more than 1,000,000, more preferably not more than 700,000, and even more preferably 400,000 or less.

The number average molecular weight and the weight average molecular weight can be measured by gel permeation chromatography (GPC), using a calibration curve of standard polystyrenes.

### (Production Method)

The charge transport polymer can be produced by various synthesis methods, and there are no particular limitations. For example, conventional coupling reactions such as the Suzuki coupling, Negishi coupling, Sonogashira coupling, Stille coupling and Buchwald-Hartwig coupling reactions can be used. The Suzuki coupling is a reaction in which a cross-coupling reaction is initiated between an aromatic boronic acid derivative and an aromatic halide using a Pd catalyst. By using a Suzuki coupling, the charge transport polymer can be produced easily by bonding together the desired aromatic rings.

In the coupling reaction, a Pd(0) compound, Pd(II) compound, or Ni compound or the like is used as a catalyst. Further, a catalyst species generated by mixing a precursor such as tris(dibenzylideneacetone)dipalladium(0) or palladium(II) acetate with a phosphine ligand can also be used. Reference may also be made to WO 2010/140553 in relation to synthesis methods for the charge transport polymer.

### [Dopant]

The organic electronic material may also contain a dopant. There are no particular limitations on the dopant, provided it is a compound that yields a doping effect upon addition to the organic electronic material, enabling an improvement in the charge transport properties. Doping includes both p-type doping and n-type doping. In p-type doping, a substance that functions as an electron acceptor is used as the dopant, whereas in n-type doping, a substance that functions as an electron donor is used as the dopant. To improve the hole transport properties, p-type doping is preferably used, whereas to improve the electron transport properties, n-type doping is preferably used. The dopant used in the organic electronic material may be a dopant that exhibits either a p-type doping effect or an n-type doping effect. Further, a single type of dopant may be added alone, or a mixture of a plurality of dopant types may be added.

The dopants used in p-type doping are electron-accepting compounds, and examples include Lewis acids, protonic acids, transition metal compounds, ionic compounds, halogen compounds and π-conjugated compounds. Specific examples include Lewis acids such as FeCl₃, PF₅, AsF₅, SbF₅, BF₅, BCl₃ and BBr₃; protonic acids, including inorganic acids such as HF, HCl, HBr, HNO₃, H₂SO₄ and HClO₄, and organic acids such as benzenesulfonic acid, p-toluenesulfonic acid, dodecylbenzenesulfonic acid, polyvinylsulfonic acid, methanesulfonic acid, trifluoromethanesulfonic acid, trifluoroacetic acid, 1-butanesulfonic acid, vinylphenylsulfonic acid and camphorsulfonic acid; transition metal compounds such as FeOCl, TiCl₄, ZrCl₄, HfCl₄, NbF₅, AlCl₃, NbCl₅, TaCl₅ and MoF₅; ionic compounds, including salts containing a perfluoro anion such as a tetrakis(pentafluorophenyl)borate ion, tris(trifluoromethanesulfonyl)methide ion, bis(trifluoromethanesulfonyl)imide ion, hexafluoroantimonate ion, AsF₆⁻ (hexafluoroarsenate ion), BF₄⁻ (tetrafluoroborate ion) or PF₆⁻ (hexafluorophosphate ion), and salts having a conjugate base of an aforementioned protonic acid as an anion; halogen compounds such as Cl₂, Br₂, I₂, ICl, ICl₃, IBr and IF; and π-conjugated compounds such as TCNE (tetracyanoethylene) and TCNQ (tetracyanoquinodimethane). Further, the electron-accepting compounds disclosed in JP 2000-36390 A, JP 2005-75948 A, and JP 2003-213002 A and the like can also be used. Lewis acids, ionic compounds, and π-conjugated compounds and the like are preferred.

Furthermore, the ionic compound preferably contains an onium salt. Examples of the onium salt include salts of an anion such as a perfluoro anion, and a cation such as an iodonium ion, sulfonium ion, ammonium ion or phosphonium ion. Specific examples include salts of the perfluoro anion shown below, and the iodonium ion or ammonium ion shown below.

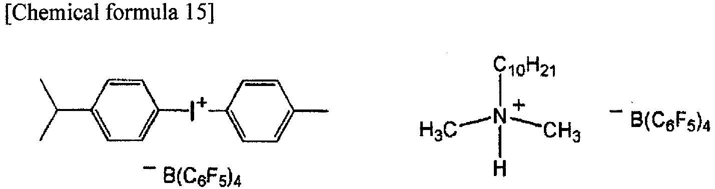

The dopants used in n-type doping are electron-donating compounds, and examples include alkali metals such as Li and Cs; alkaline earth metals such as Mg and Ca; salts of alkali metals and/or alkaline earth metals such as LiF and Cs₂CO₃; metal complexes; and electron-donating organic compounds.

In those cases where the charge transport polymer has a polymerizable functional group, in order to make it easier to change the solubility of the organic layer, the use of a compound that can function as a polymerization initiator for the polymerizable functional group as the dopant is preferred.

### [Other Optional Components]

The organic electronic material may also contain charge transport low-molecular weight compounds, or other polymers or the like.

### [Contents]

From the viewpoint of obtaining favorable charge transport properties, the amount of the charge transport polymer, relative to the total mass of the organic electronic material, is preferably at least 50% by mass, more preferably at least 70% by mass, and even more preferably 80% by mass or greater. The amount may be 100% by mass.

When a dopant is included, from the viewpoint of improving the charge transport properties of the organic electronic material, the amount of the dopant relative to the total mass of the organic electronic material is preferably at least 0.01% by mass, more preferably at least 0.1% by mass, and even more preferably 0.5% by mass or greater. Further, from the viewpoint of maintaining favorable film formability, the amount of the dopant relative to the total mass of the organic electronic material is preferably not more than 50% by mass, more preferably not more than 30% by mass, and even more preferably 20% by mass or less.

### <Ink Composition>

The organic electronic material described above may also contain a solvent capable of dissolving or dispersing the material, thus forming an ink composition. In one embodiment, an ink composition contains the organic electronic material of an embodiment described above, and a solvent that is capable of dissolving or dispersing the material. The ink composition may, if necessary, also contain various conventional additives, provided the characteristics provided by the organic electronic material are not impaired. By using an ink composition, an organic layer can be formed easily using a simple coating method.

### [Solvent]

Water, organic solvents, or mixed solvents thereof can be used as the solvent. Examples of the organic solvent include alcohols such as methanol, ethanol and isopropyl alcohol; alkanes such as pentane, hexane and octane; cyclic alkanes such as cyclohexane; aromatic hydrocarbons such as benzene, toluene, xylene, mesitylene, tetralin and diphenylmethane; aliphatic ethers such as ethylene glycol dimethyl ether, ethylene glycol diethyl ether and propylene glycol-1-monomethyl ether acetate; aromatic ethers such as 1,2-dimethoxybenzene, 1,3-dimethoxybenzene, anisole, phenetole, 2-methoxytoluene, 3-methoxytoluene, 4-methoxytoluene, 2,3-dimethylanisole and 2,4-dimethylanisole; aliphatic esters such as ethyl acetate, n-butyl acetate, ethyl lactate and n-butyl lactate; aromatic esters such as phenyl acetate, phenyl propionate, methyl benzoate, ethyl benzoate, propyl benzoate and n-butyl benzoate; amide-based solvents such as N,N-dimethylformamide and N,N-dimethylacetamide; as well as dimethyl sulfoxide, tetrahydrofuran, acetone, chloroform and methylene chloride and the like. Preferred solvents include aromatic hydrocarbons, aliphatic esters, aromatic esters, aliphatic ethers, and aromatic ethers and the like.

### [Polymerization Initiator]

In those cases where the charge transport polymer has a polymerizable functional group, the ink composition preferably contains a polymerization initiator. Conventional radical polymerization initiators, cationic polymerization initiators, and anionic polymerization initiators and the like can be used as the polymerization initiator. From the viewpoint of enabling simple preparation of the ink composition, the use of a substance that exhibits both a function as a dopant and a function as a polymerization initiator is preferred. Examples of such substances include the ionic compounds described above.

### [Additives]

The ink composition may also contain additives as optional components. Examples of these additives include polymerization inhibitors, stabilizers, thickeners, gelling agents, flame retardants, antioxidants, reduction inhibitors, oxidizing agents, reducing agents, surface modifiers, emulsifiers, antifoaming agents, dispersants and surfactants.

### [Contents]

The amount of the solvent in the ink composition can be determined with due consideration of the use of the composition in various coating methods. For example, the amount of the solvent is preferably an amount that yields a ratio of the charge transport polymer relative to the solvent that is at least 0.1% by mass, more preferably at least 0.2% by mass, and even more preferably 0.5% by mass or greater. Further, the amount of the solvent is preferably an amount that yields a ratio of the charge transport polymer relative to the solvent that is not more than 20% by mass, more preferably not more than 15% by mass, and even more preferably 10% by mass or less.

### <Organic Layer (Organic Thin Film)>

In one embodiment, an organic layer is a layer formed using the organic electronic material or the ink composition of an embodiment described above. By using the ink composition, an organic layer can be formed favorably by a coating method.

Accordingly, one example of a method for producing the organic layer according to one embodiment of the present invention includes a step of applying the ink composition. Examples of the coating method include conventional methods such as spin coating methods; casting methods; dipping methods; plate-based printing methods such as relief printing, intaglio printing, offset printing, lithographic printing, relief reversal offset printing, screen printing and gravure printing; and plateless printing methods such as inkjet methods. When the organic layer is formed by a coating method, the organic layer (coating layer) obtained following coating may be dried using a hotplate or an oven to remove the solvent. Accordingly, the method for producing the organic layer may also include optional steps such as a step of drying the organic layer (namely, the coating layer) obtained following coating using a hotplate or an oven to remove the solvent, and a step of curing the curing the coating layer.

In those cases where the charge transport polymer has a polymerizable functional group, the charge transport polymer can be subjected to a polymerization reaction by performing light irradiation or a heat treatment or the like, thereby changing the solubility of the organic layer. By stacking organic layers for which the solubility levels have been changed, multilayering of an organic electronic element can be performed with ease. Reference may also be made to WO 2010/140553 in relation to the method used for forming the organic layer.

From the viewpoint of improving the efficiency of charge transport, the thickness of the organic layer obtained following drying or curing is preferably at least 0.1 nm, more preferably at least 1 nm, and even more preferably 3 nm or greater. Further, from the viewpoint of reducing the electrical resistance, the thickness of the organic layer is preferably not more than 300 nm, more preferably not more than 200 nm, and even more preferably 100 nm or less.

### <Organic Electronic Element>

In one embodiment, an organic electronic element has at least the organic layer of the embodiment described above. Examples of the organic electronic element include an organic EL element, an organic photoelectric conversion element, and an organic transistor. The organic electronic element preferably has at least a structure in which the organic layer is disposed between a pair of electrodes.

### [Organic EL Element]

In one embodiment, an organic EL element has at least the organic layer of the embodiment described above. The organic EL element typically includes a light-emitting layer, an anode, a cathode and a substrate, and if necessary, may also have other functional layers such as a hole injection layer, electron injection layer, hole transport layer and electron transport layer. Each layer may be formed by a vapor deposition method, or by a coating method. The organic EL element preferably has the organic layer as the light-emitting layer or as another functional layer, more preferably has the organic layer as a functional layer, and even more preferably has the organic layer as at least one of a hole injection layer and a hole transport layer.

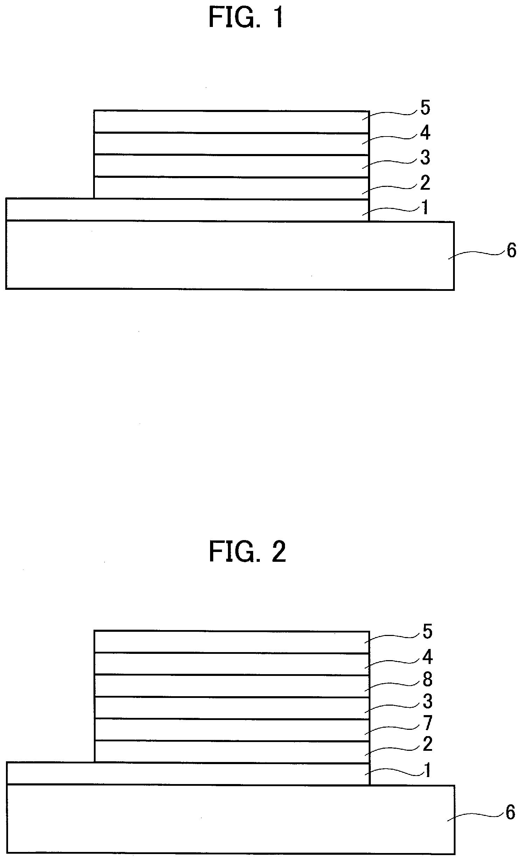

FIG. 1 and FIG. 2 are cross-sectional schematic views each illustrating an embodiment of the organic EL element. The organic EL element illustrated in FIG. 1 is an element with a multilayer structure, and has an anode 1, a hole injection layer 2, a light-emitting layer 3, an electron injection layer 4 and a cathode 5 provided in that order on top of a substrate 6. In one embodiment, the hole injection layer 2 is formed from an organic layer according to an embodiment of the present invention.

The organic EL element illustrated in FIG. 2 is an element with a multilayer structure, and has an anode 1, a hole injection layer 2, a hole transport layer 7, a light-emitting layer 3, an electron transport layer 8, an electron injection layer 4 and a cathode 5 provided in that order on top of a substrate 6. In one embodiment, at least one of the hole injection layer 2 and the hole transport layer 7 is formed from an organic layer according to an embodiment of the present invention. In one embodiment, the hole injection layer 2 and the hole transport layer 7 are both composed of organic layers formed using the organic electronic material described above. The organic EL element according to an embodiment of the present invention is not limited to these types of structures, and other organic layers may also be organic layers formed using the organic electronic material described above. Each of the layers is described below.

### [Light-Emitting Layer]

Examples of the material used for the light-emitting layer include light-emitting materials such as low-molecular weight compounds, polymers and dendrimers. Polymers exhibit good solubility in solvents, meaning they are suitable for coating methods, and are consequently preferred. Examples of the light-emitting material include fluorescent materials, phosphorescent materials, and thermally activated delayed fluorescent materials (TADF).

Specific examples of the fluorescent materials include low-molecular weight compounds such as perylene, coumarin, rubrene, quinacridone, stilbene, color laser dyes, aluminum complexes, and derivatives of these compounds; polymers such as polyfluorene, polyphenylene, polyphenylenevinylene, polyvinylcarbazole, fluorene-benzothiadiazole copolymers, fluorene-triphenylamine copolymers, and derivatives of these compounds; and mixtures of the above materials.

Examples of materials that can be used as the phosphorescent materials include metal complexes and the like containing a metal such as Ir or Pt or the like. Specific examples of Ir complexes include FIr(pic) (iridium(III) bis[(4,6-difluorophenyl)-pyridinato-N,C²]picolinate) which emits blue light, Ir(ppy)₃ (fac-tris(2-phenylpyridine)iridium) which emits green light, and (btp)₂Ir(acac)(bis[2-(2'-benzo[4,5-α]thienyl)pyridinato-N,C³]iridium(acetyl-acetonate)) and Ir(piq)₃ (tris(1-phenylisoquinoline)iridium) which emit red light. Specific examples of Pt complexes include PtOEP (2,3,7,8,12,13,17,18-octaethyl-21H,23H-porphyrin-platinum) which emits red light.

When the light-emitting layer contains a phosphorescent material, a host material is preferably also included in addition to the phosphorescent material. Low-molecular weight compounds, polymers, and dendrimers can be used as this host material. Examples of the low-molecular weight compounds include CBP (4,4'-bis(carbazol-9-yl)-biphenyl), mCP (1,3-bis(9-carbazolyl)benzene), CDBP (4,4'-bis(carbazol-9-yl)-2,2'-dimethylbiphenyl), and derivatives of these compounds, whereas examples of the polymers include the organic electronic material of the embodiment described above, polyvinylcarbazole, polyphenylene, polyfluorene, and derivatives of these polymers.

Examples of the thermally activated delayed fluorescent materials include the compounds disclosed in Adv. Mater., 21, 4802-4906 (2009); Appl. Phys. Lett., 98, 083302 (2011); Chem. Comm., 48, 9580 (2012); Appl. Phys. Lett., 101, 093306 (2012); J. Am. Chem. Soc., 134, 14706 (2012); Chem. Comm., 48, 11392 (2012); Nature, 492, 234 (2012); Adv. Mater., 25, 3319 (2013); J. Phys. Chem. A, 117, 5607 (2013); Phys. Chem. Chem. Phys., 15, 15850 (2013); Chem. Comm., 49, 10385 (2013); and Chem. Lett., 43, 319 (2014) and the like.

### [Hole Injection Layer, Hole Transport Layer]

In one embodiment, the organic electronic material described above is used as the material for forming a hole injection layer and a hole transport layer. However, the organic EL element of the present embodiment is not limited to this type of structure, and other organic layers may be organic layers formed using the organic electronic material described above. An organic layer formed using the above organic electronic material is preferably used for at least one of a hole transport layer and a hole injection layer.

For example, in the case where the organic EL element has an organic layer formed using the above organic electronic material as a hole transport layer, and also has a hole injection layer, a conventional material may be used for the hole injection layer. Further, in the case where, for example, the organic EL element has an organic layer formed using the above organic electronic material as a hole injection layer, and also has a hole transport layer, a conventional material may be used for the hole transport layer.

Examples of conventional materials that can be used for the hole injection layer and the hole transport layer include aromatic amine-based compounds (for example, aromatic diamines such as N,N'-di(naphthalen-1-yl)-N,N'-diphenyl-benzidine (α-NPD)), phthalocyanine-based compounds, and thiophene-based compounds (for example, poly(3,4-ethylenedioxythiophene):poly(4-styrenesulfonate) (PEDOT:PSS) and the like).

### [Electron Transport Layer, Electron Injection Layer]

Examples of materials that can be used for the electron transport layer and the electron injection layer include phenanthroline derivatives, bipyridine derivatives, nitro-substituted fluorene derivatives, diphenylquinone derivatives, thiopyran dioxide derivatives, condensed-ring tetracarboxylic acid anhydrides of naphthalene and perylene and the like, carbodiimides, fluorenylidenemethane derivatives, anthraquinodimethane and anthrone derivatives, oxadiazole derivatives, thiadiazole derivatives, benzimidazole derivatives (for example, TPBi), quinoxaline derivatives, and aluminum complexes (for example, BAlq). Further, the organic electronic material of the embodiment described above may also be used.

### [Cathode]

Examples of the cathode material include metals or metal alloys, such as Li, Ca, Mg, Al, In, Cs, Ba, Mg/Ag, LiF and CsF.

### [Anode]

Metals (for example, Au) or other materials having conductivity can be used as the anode. Examples of the other materials include oxides (for example, ITO: indium oxide/tin oxide, and conductive polymers (for example, polythiophene-polystyrene sulfonate mixtures (PEDOT:PSS)).

### [Substrate]

Glass and plastics and the like can be used as the substrate. The substrate is preferably transparent, and preferably has flexibility. Quartz glass and light-transmitting resin films and the like can be used particularly favorably.

Examples of the resin films include films composed of polyethylene terephthalate, polyethylene naphthalate, polyethersulfone, polyetherimide, polyetheretherketone, polyphenylene sulfide, polyarylate, polyimide, polycarbonate, cellulose triacetate or cellulose acetate propionate.

In those cases where a resin film is used, an inorganic substance such as silicon oxide or silicon nitride may be coated onto the resin film to inhibit the transmission of water vapor and oxygen and the like.

### [Emission Color]

There are no particular limitations on the color of the light emission from the organic EL element. White organic EL elements can be used for various illumination fixtures, including domestic lighting, in-vehicle lighting, watches and liquid crystal backlights, and are consequently preferred.

The method used for forming a white organic EL element may employ a method in which a plurality of light-emitting materials are used to emit a plurality of colors simultaneously, which are then mixed to obtain a white light emission. There are no particular limitations on the combination of the plurality of emission colors, and examples include combinations that include three maximum emission wavelengths for blue, green and red, and combinations that include two maximum emission wavelengths and utilize the complementary color relationship between blue and yellow, or yellowish green and orange or the like. Control of the emission color can be achieved by appropriate adjustment of the types and amounts of the light-emitting materials.

### <Display Element, Illumination Device, Display Device>

In one embodiment, a display element contains the organic EL element of the embodiment described above. For example, by using the organic EL element as the element corresponding with each color pixel of red, green and blue (RGB), a color display element can be obtained. Examples of the image formation method include a simple matrix in which organic EL elements arrayed in a panel are driven directly by an electrode arranged in a matrix, and an active matrix in which a thin-film transistor is positioned on, and drives, each element.

Furthermore, an illumination device according to an embodiment of the present invention contains the organic EL element of an embodiment of the present invention. Moreover, a display device according to an embodiment of the present invention contains the illumination device and a liquid crystal element as a display unit. For example, the display device may be a device that uses the illumination device of an embodiment of the present invention as a backlight, and uses a conventional liquid crystal element as the display unit, namely a liquid crystal display device.

### EXAMPLES

The present invention is described below in further detail using a series of examples, but the present invention is not limited by the following examples.

### [A: Examples 1A to 5A, Comparative Examples 1A to 4A]

### <Preparation of Pd Catalyst>

In a glove box under a nitrogen atmosphere and at room temperature, tris(dibenzylideneacetone)dipalladium (73.2 mg, 80 µmol) was weighed into a sample tube, anisole (15 mL) was added, and the resulting mixture was agitated for 30 minutes. In a similar manner, tris(t-butyl)phosphine (129.6 mg, 640 µmol) was weighed into a sample tube, anisole (5 mL) was added, and the resulting mixture was agitated for 5 minutes. The two solutions were then mixed together and stirred for 30 minutes at room temperature to obtain a catalyst. All the solvents used were deaerated by nitrogen bubbling for at least 30 minutes prior to use.

### <Synthesis of Charge Transport Polymer 1A>

A three-neck round-bottom flask was charged with a monomer B-1 shown below (2.0 mmol), a monomer L-1 shown below (5.0 mmol), a monomer T-1 shown below (4.0 mmol) and anisole (20 mL), and the prepared Pd catalyst solution (7.5 mL) was then added. After stirring for 30 minutes, a 10% aqueous solution of tetraethylammonium hydroxide (20 mL) was added. All of the solutions were deaerated by nitrogen bubbling for at least 30 minutes prior to use. The resulting mixture was heated and refluxed for 2 hours. All the operations up to this point were conducted under a stream of nitrogen.

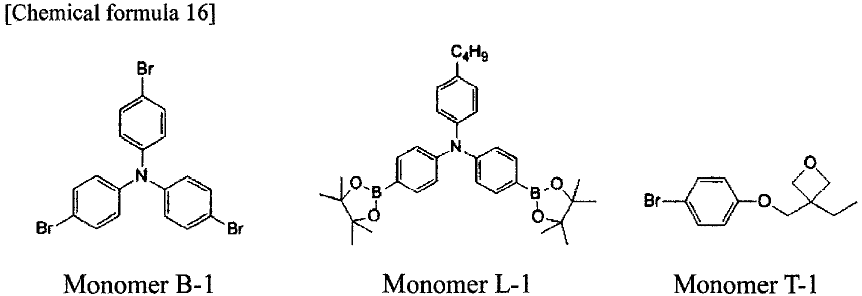

After completion of the reaction, the organic layer was washed with water, and was then poured into methanol-water (9:1). The resulting precipitate was collected by filtration under reduced pressure, and washed with methanol-water (9:1). The washed precipitate was dissolved in toluene, and re-precipitated from methanol. The thus obtained precipitate was collected by filtration under reduced pressure and then dissolved in toluene, and a metal adsorbent ("Triphenylphosphine, polymer-bound on styrene-divinylbenzene copolymer", manufactured by Strem Chemicals Inc., 200 mg per 100 mg of the precipitate) was then added to the solution and stirred overnight. Following completion of the stirring, the metal adsorbent and other insoluble matter were removed by filtration, and the filtrate was concentrated using a rotary evaporator. The concentrate was dissolved in toluene, and then re-precipitated from methanol-acetone (8:3). The thus produced precipitate was collected by filtration under reduced pressure and washed with methanol-acetone (8:3). The thus obtained precipitate was then dried under vacuum to obtain a charge transport polymer 1A. The molecular weight was measured by GPC (relative to polystyrene standards) using THF as an eluent. The obtained charge transport polymer 1A had a number average molecular of 15,100 and a weight average molecular weight of 58,200.

The number average molecular weight and the weight average molecular weight were measured by GPC (relative to polystyrene standards) using tetrahydrofuran (THF) as the eluent. The measurement conditions were as follows.
Feed pump: L-6050, manufactured by Hitachi High-Technologies Corporation
UV-Vis detector: L-3000, manufactured by Hitachi High-Technologies Corporation
Columns: Gelpack (a registered trademark) GL-A160S / GL-A150S, manufactured by Hitachi Chemical Co., Ltd.
Eluent: THF (for HPLC, stabilizer-free), manufactured by Wako Pure Chemical Industries, Ltd.
Flow rate: 1 mL/min
Column temperature: room temperature
Molecular weight standards: standard polystyrenes

### <Synthesis of Charge Transport Polymer 2A>

A three-neck round-bottom flask was charged with a monomer B1-1 shown below (2.0 mmol), the monomer L-1 shown above (5.0 mmol), the monomer T-1 shown above (4.0 mmol) and anisole (20 mL), and the prepared Pd catalyst solution (7.5 mL) was then added. Thereafter, synthesis of a charge transport polymer 2A was performed in the same manner as the synthesis of the charge transport polymer 1A. The obtained charge transport polymer 2A had a number average molecular of 35,800 and a weight average molecular weight of 88,000.

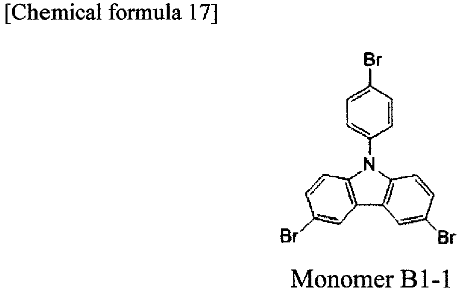

### <Synthesis of Charge Transport Polymer 3A>

A three-neck round-bottom flask was charged with a monomer B1-2 shown below (2.0 mmol), the monomer L-1 shown above (5.0 mmol), the monomer T-1 shown above (4.0 mmol) and anisole (20 mL), and the prepared Pd catalyst solution (7.5 mL) was then added. Thereafter, synthesis of a charge transport polymer 3A was performed in the same manner as the synthesis of the charge transport polymer 1A. The obtained charge transport polymer 3A had a number average molecular of 20,900 and a weight average molecular weight of 72,100.

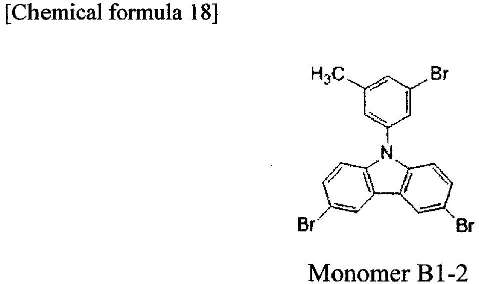

### <Synthesis of Charge Transport Polymer 4A>

A three-neck round-bottom flask was charged with a monomer B1-3 shown below (2.0 mmol), the monomer L-1 shown above (5.0 mmol), the monomer T-1 shown above (4.0 mmol) and anisole (20 mL), and the prepared Pd catalyst solution (7.5 mL) was then added. Thereafter, synthesis of a charge transport polymer 4A was performed in the same manner as the synthesis of the charge transport polymer 1A. The obtained charge transport polymer 4A had a number average molecular of 44,500 and a weight average molecular weight of 191,300.

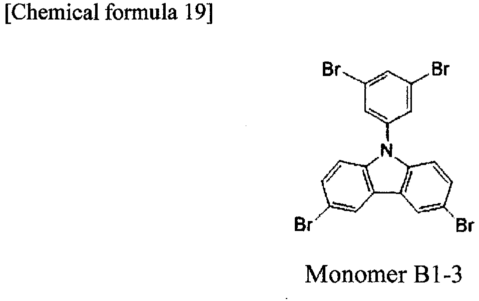

### <Synthesis of Charge Transport Polymer 5A>

A three-neck round-bottom flask was charged with the monomer B-1 shown above (2.0 mmol), a monomer L-2 shown below (5.0 mmol), the monomer T-1 shown above (4.0 mmol) and anisole (20 mL), and the prepared Pd catalyst solution (7.5 mL) was then added. Thereafter, synthesis of a charge transport polymer 5A was performed in the same manner as the synthesis of the charge transport polymer 1A. The obtained charge transport polymer 5A had a number average molecular of 7,800 and a weight average molecular weight of 22,000.

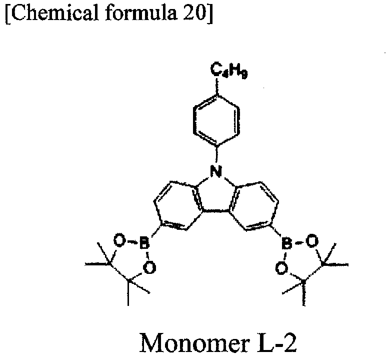

### <Synthesis of Charge Transport Polymer 6A>

A three-neck round-bottom flask was charged with the monomer B1-2 shown above (2.0 mmol), the monomer L-2 shown above (5.0 mmol), the monomer T-1 shown above (4.0 mmol) and anisole (20 mL), and the prepared Pd catalyst solution (7.5 mL) was then added. Thereafter, synthesis of a charge transport polymer 6A was performed in the same manner as the synthesis of the charge transport polymer 1A. The obtained charge transport polymer 6A had a number average molecular of 31,800 and a weight average molecular weight of 161,900.

The monomers used in synthesizing each of the charge transport polymers are summarized below in Table A1. The monomers B1-1, B1-2 and B1-3 used in synthesis of the polymers shown in Table A1 each correspond with a monomer that forms a trivalent or higher valent structural unit having a 9-phenylcarbazole structure. Further, the monomer L-2 corresponds with a monomer that forms a divalent structural unit having a 9-phenylcarbazole structure. Among the various monomers, the monomers B1-2 and B1-3 correspond with structures having a hydrogen atom at position 4 of the phenyl group of the 9-phenylcarbazole moiety.

**[Table A1]**

| | Monomers used | | |
|---|---|---|---|
| Charge transport polymer 1A | Monomer B-1 | Monomer L-1 | Monomer T-1 |
| Charge transport polymer 2A | Monomer B1-1 | Monomer L-1 | Monomer T-1 |
| Charge transport polymer 3A | Monomer B1-2 | Monomer L-1 | Monomer T-1 |
| Charge transport polymer 4A | Monomer B1-3 | Monomer L-1 | Monomer T-1 |
| Charge transport polymer 5A | Monomer B-1 | Monomer L-2 | Monomer T-1 |
| Charge transport polymer 6A | Monomer B1-2 | Monomer L-2 | Monomer T-1 |

### <Measurement of Triplet State (T1) Level>

The triplet state (T1) level of a charge transport polymer was calculated from the wavelength maximum (λmax) in a phosphorescence spectrum measured using a 2-methyltetrahydrofuran solution (77K) of the charge transport polymer. Measurement of the phosphorescence spectrum was performed using an F-7000 fluorescence spectrophotometer and an associated low-temperature measurement device manufactured by Hitachi High-Tech Science Corporation.

The results are shown in Table A2.

**[Table A2]**

| | λmax (nm) | T1 (eV) |
|---|---|---|
| Charge transport polymer 1A | 530 | 2.34 |
| Charge transport polymer 2A | 515 | 2.41 |
| Charge transport polymer 3A | 504 | 2.46 |
| Charge transport polymer 4A | 502 | 2.47 |
| Charge transport polymer 5A | 516 | 2.41 |
| Charge transport polymer 6A | 479 | 2.59 |

It is evident that the charge transport polymers 2A to 6A that contained a 9-phenylcarbazole moiety within the molecule had a higher T1 level than the charge transport polymer 1A that did not contain a 9-phenylcarbazole moiety within the molecule. It is also evident that, among the various polymers, the charge transport polymers 3A, 4A and 6A that contained a 9-phenylcarbazole moiety having a hydrogen atom at position 4 of the phenyl group had a higher T1 level than the other charge transport polymers.

The following description relates to investigation of embodiments containing a charge transport polymer that includes a 9-phenylcarbazole moiety, also includes a structure branched in at least three directions from the 9-phenylcarbazole moiety, and has a hydrogen atom at position 4 of the phenyl group of the 9-phenylcarbazole moiety.

### <Production and Evaluation of Organic EL Elements>

### <Organic EL Elements Containing Charge transport Polymer in Hole Injection Layer>

### [Example 1A]

Under a nitrogen atmosphere, the charge transport polymer 3A (10.0 mg), a dopant 1 shown below (0.5 mg) and toluene (2.3 mL) were mixed together to prepare an ink composition.

The ink composition was spin-coated at a rotational rate of 3,000 min⁻¹ onto a glass substrate on which ITO had been patterned with a width of 1.6 mm, and was then cured by heating at 220°C for 10 minutes on a hotplate, thus forming a hole injection layer (30 nm).

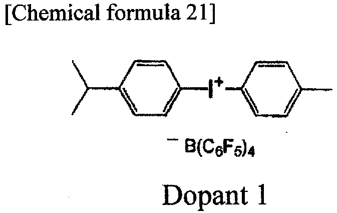

The glass substrate was transferred into a vacuum deposition apparatus, and layers of α-NPD (40 nm), CBP:Ir(ppy)₃ (94:6, 30 nm), BAlq (10 nm), TPBi (30 nm), LiF (0.8 nm) and Al (100 nm) were deposited in that order using deposition methods on top of the hole injection layer. An encapsulation treatment was then performed to complete production of an organic EL element.

### [Example 2A]

With the exception of replacing the charge transport polymer 3A with the charge transport polymer 4A in the formation step for the hole injection layer in the organic EL element of Example 1A, an organic EL element was produced in the same manner as Example 1A.

### [Comparative Example 1A]

With the exception of replacing the charge transport polymer 3A with the charge transport polymer 1A in the formation step for the hole injection layer in the organic EL element of Example 1A, an organic EL element was produced in the same manner as Example 1A.

### [Comparative Example 2A]

With the exception of replacing the charge transport polymer 3A with the charge transport polymer 2A in the formation step for the hole injection layer in the organic EL element of Example 1A, an organic EL element was produced in the same manner as Example 1A.

The materials used for the hole injection layer formation of the organic EL elements in the above Examples 1A and 2A, and Comparative Examples 1A and 2A are summarized in Table A3.

**[Table A3]**

| | Materials used for hole injection layer formation |
|---|---|
| Example 1A | Charge transport polymer 3A, Dopant 1 |
| Example 2A | Charge transport polymer 4A, Dopant 1 |
| Comparative Example 1A | Charge transport polymer 1A, Dopant 1 |
| Comparative Example 2A | Charge transport polymer 2A, Dopant 1 |

When a voltage was applied to the organic EL elements obtained in Examples 1A and 2A and Comparative Examples 1A and 2A, green light emission was confirmed in each case. For each element, the emission efficiency at a luminance of 5,000 cd/m² and the emission lifespan (luminance half-life) when the initial luminance was 5,000 cd/m² were measured. The measurement results are shown in Table A4. Measurement of the luminance was performed using an SR-3AR device manufactured by Topcon Technohouse Corporation.

**[Table A4]**

| | Emission efficiency (cd/A) | Emission lifespan (h) |
|---|---|---|
| Example 1A | 25.4 | 365.4 |
| Example 2A | 24.9 | 353.8 |
| Comparative Example 1A | 22.0 | 282.7 |
| Comparative Example 2A | 22.2 | 293.4 |

As illustrated in Table A4, in Examples 1A and 2A, long-life organic EL elements having superior emission efficiency and excellent drive stability were able to be obtained. Based on Examples 1A and 2A, it is evident that a charge transport polymer having a specific 9-phenylcarbazole moiety yielded effects including an improvement in the emission efficiency and an improvement in the lifespan.

### <Organic EL Elements Containing Charge transport Polymer in Hole Transport Layer>

### [Example 3A]

Under a nitrogen atmosphere, the charge transport polymer 1A (10.0 mg), the dopant 1 shown above (0.5 mg) and toluene (2.3 mL) were mixed together to prepare an ink composition.

The ink composition was spin-coated at a rotational rate of 3,000 min⁻¹ onto a glass substrate on which ITO had been patterned with a width of 1.6 mm, and was then cured by heating at 220°C for 10 minutes on a hotplate, thus forming a hole injection layer (30 nm).

Next, the charge transport polymer 6A (20.0 mg), a dopant 2 shown below (0.5 mg) and toluene (2.3 mL) were mixed together to prepare another ink composition. This ink composition was spin-coated at a rotational rate of 3,000 min⁻¹ onto the hole injection layer, and was then cured by heating at 200°C for 10 minutes on a hotplate, thus forming a hole transport layer (40 nm). The hole transport layer was able to be formed without dissolving the hole injection layer.

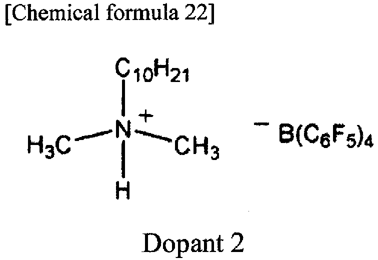

The glass substrate was transferred into a vacuum deposition apparatus, and layers of CBP:Ir(ppy)₃ (94:6, 30 nm), BAlq (10 nm), TPBi (30 nm), LiF (0.8 nm) and Al (100 nm) were deposited in that order using deposition methods on top of the hole transport layer. An encapsulation treatment was then performed to complete production of an organic EL element.

### [Example 4A]

With the exception of replacing the charge transport polymer 1A with the charge transport polymer 3A in the formation step for the hole injection layer in the organic EL element of Example 3A, an organic EL element was produced in the same manner as Example 3A.

### [Comparative Example 3A]

With the exception of replacing the charge transport polymer 6A with the charge transport polymer 5A in the formation step for the hole transport layer in the organic EL element of Example 3A, an organic EL element was produced in the same manner as Example 3A.

The materials used for forming the hole injection layer and the hole transport layer of the organic EL element in the above Examples 3A and 4A, and Comparative Example 3A are summarized in Table A5.

**[Table A5]**

| | Materials used for hole injection layer formation | Materials used for hole transport layer formation |
|---|---|---|
| Example 3A | Charge transport polymer 1A Dopant 1 | Charge transport polymer 6A Dopant 2 |
| Example 4A | Charge transport polymer 3A Dopant 1 | Charge transport polymer 6A Dopant 2 |
| Comparative Example 3A | Charge transport polymer 1A Dopant 1 | Charge transport polymer 5A Dopant 2 |

When a voltage was applied to the organic EL elements obtained in Examples 3A and 4A and Comparative Example 3A, green light emission was confirmed in each case. For each element, the emission efficiency at a luminance of 5,000 cd/m² and the emission lifespan (luminance half-life) when the initial luminance was 5,000 cd/m² were measured. The measurement results are shown in Table A6. Measurement of the luminance was performed using an SR-3AR device manufactured by Topcon Technohouse Corporation.

**[Table A6]**

| | Emission efficiency (cd/A) | Emission lifespan (h) |
|---|---|---|
| Example 3A | 35.2 | 95.8 |
| Example 4A | 36.1 | 103.7 |
| Comparative Example 3A | 28.6 | 72.1 |

As illustrated in Table A6, in Examples 3A and 4A, long-life organic EL elements having superior emission efficiency and excellent drive stability were able to be obtained. Based on Examples 3A and 4A, it is evident that when a charge transport polymer having a specific 9-phenylcarbazole moiety was used, effects including an improvement in the emission efficiency and an improvement in the lifespan were able to be obtained.

### <Production and Evaluation of White Organic EL Elements (Illumination Devices)>

### [Example 5A]

Under a nitrogen atmosphere, the charge transport polymer 2A (10.0 mg), the dopant 1 shown above (0.5 mg) and toluene (2.3 mL) were mixed together to prepare an ink composition.

The ink composition was spin-coated at a rotational rate of 3,000 min⁻¹ onto a glass substrate on which ITO had been patterned with a width of 1.6 mm, and was then cured by heating at 220°C for 10 minutes on a hotplate, thus forming a hole injection layer (30 nm).

Next, the charge transport polymer 6A (20.0 mg), the dopant 2 shown above (0.5 mg) and toluene (2.3 mL) were mixed together to prepare another ink composition. This ink composition was spin-coated at a rotational rate of 3,000 min⁻¹ onto the hole injection layer, and was then cured by heating at 200°C for 10 minutes on a hotplate, thus forming a hole transport layer (40 nm). The hole transport layer was able to be formed without dissolving the hole injection layer.

Subsequently, under a nitrogen atmosphere, CDBP (15 mg), Flr(pic) (0.9 mg), Ir(ppy)₃ (0.9 mg), btp₂Ir(acac) (1.2 mg) and dichlorobenzene (0.5 mL) were mixed together to prepare another ink composition. This ink composition was spin-coated at a rotational rate of 3,000 min⁻¹, and was then dried by heating at 80°C for 5 minutes, thus forming a light-emitting layer (40 nm). The light-emitting layer was able to be formed without dissolving the hole transport layer.

The glass substrate was then transferred into a vacuum deposition apparatus, and layers of BAlq (10 nm), TPBi (30 nm), LiF (0.8 nm) and Al (100 nm) were deposited in that order using deposition methods on top of the light-emitting layer. An encapsulation treatment was then performed to complete production of a white organic EL element. The white organic EL element was able to be used as an illumination device.

### [Comparative Example 4A]

With the exceptions of replacing the charge transport polymer 2A with the charge transport polymer 1A in the formation step for the hole injection layer in the organic EL element of Example 5A, and replacing the charge transport polymer 6A with the charge transport polymer 5A in the formation step for the hole transport layer, a white organic EL element was produced in the same manner as Example 5A.

A voltage was applied to the white organic EL elements obtained in Example 5A and Comparative Example 4A, and the voltage at a luminance of 1,000 cd/m², and the emission lifespan (luminance half-life) when the initial luminance was 1,000 cd/m² were measured. When the voltage for Example 5A was deemed to be 1.0, the voltage for Comparative Example 4A was 1.14. Further, when the emission lifespan for Example 5A was deemed to be 1.0, the emission lifespan for Comparative Example 4A was 0.21. The white organic EL element of Example 5A had excellent drive voltage and emission lifespan.

The effects of embodiments of the present invention have been illustrated above using a series of examples. Besides the combinations of charge transport polymers used in these examples, other combinations selected from among the charge transport polymers described above can also be used to obtain organic EL elements having long lifespans.

By using a charge transport polymer that includes a 9-phenylcarbazole moiety, has a hydrogen atom at position 4 of the phenyl group of the 9-phenylcarbazole moiety, and also includes a structure branched in at least three directions from the 9-phenylcarbazole moiety, an organic layer can be formed easily using a wet process, and an organic EL element having excellent lifespan characteristics can be obtained.

### [B: Examples 1B to 11B, Comparative Examples 1B to 9B]

The following description relates to investigation of embodiments containing a charge transport polymer that includes a 9-phenylcarbazole moiety, also includes a structure branched in at least three directions from the 9-phenylcarbazole moiety, and also has a triphenylamine structure in which at least one phenyl group has an alkoxy group.

### <I> Preparation of Charge Transport Polymers

### (Preparation of Pd Catalyst)

In a glove box under a nitrogen atmosphere and at room temperature, tris(dibenzylideneacetone)dipalladium (73.2 mg, 80 µmol) was weighed into a sample tube, anisole (15 mL) was added, and the resulting mixture was agitated for 30 minutes. In a similar manner, tris(t-butyl)phosphine (129.6 mg, 640 µmol) was weighed into a sample tube, anisole (5 mL) was added, and the resulting mixture was agitated for 5 minutes. The two solutions were then mixed together and stirred for 30 minutes at room temperature, and the resulting solution was used as a Pd catalyst solution. All the solvents used were deaerated by nitrogen bubbling for at least 30 minutes prior to use.

### (Charge Transport Polymer 1B)

A three-neck round-bottom flask was charged with a monomer B1-1 shown below (2.0 mmol), a monomer L1 shown below (5.0 mmol), a monomer T-1 shown below (1.0 mmol), a monomer T-2 shown below (3.0 mmol) and anisole (20 mL), and the prepared Pd catalyst solution (7.5 mL) was then added. This reaction solution was stirred for 30 minutes, and then a 10% aqueous solution of tetraethylammonium hydroxide (20 mL) was added. All of the raw materials were deaerated by nitrogen bubbling for at least 30 minutes prior to use. The resulting mixture was heated and refluxed for 2 hours. All the operations up to this point were conducted under a stream of nitrogen.

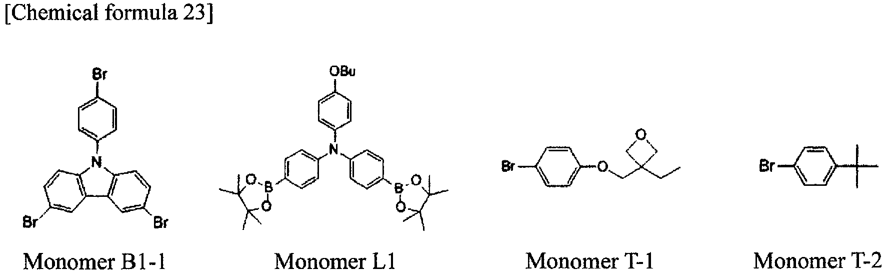

After completion of the reaction, the organic layer was washed with water, and was then poured into methanol-water (9:1). The resulting precipitate was collected by filtration under reduced pressure, and washed with methanol-water (9:1). The washed precipitate was dissolved in toluene, and re-precipitated from methanol. The thus obtained precipitate was collected by filtration under reduced pressure and then dissolved in toluene, and a metal adsorbent ("Triphenylphosphine, polymer-bound on styrene-divinylbenzene copolymer", manufactured by Strem Chemicals Inc., 200 mg per 100 mg of the precipitate) was then added to the solution and stirred overnight. Following completion of the stirring, the metal adsorbent and other insoluble matter were removed by filtration, and the filtrate was concentrated using a rotary evaporator. The concentrate was dissolved in toluene, and then re-precipitated from methanol-acetone (8:3). The thus produced precipitate was collected by filtration under reduced pressure and washed with methanol-acetone (8:3). The thus obtained precipitate was then dried under vacuum to obtain a charge transport polymer 1B.

The obtained charge transport polymer 1B had a number average molecular of 33,700 and a weight average molecular weight of 92,000.

The number average molecular weight and the weight average molecular weight were measured by GPC (relative to polystyrene standards) using tetrahydrofuran (THF) as the eluent. The measurement conditions were as follows.
Feed pump: L-6050, manufactured by Hitachi High-Technologies Corporation
UV-Vis detector: L-3000, manufactured by Hitachi High-Technologies Corporation
Columns: Gelpack (a registered trademark) GL-A160S / GL-A150S, manufactured by Hitachi Chemical Co., Ltd.
Eluent: THF (for HPLC, stabilizer-free), manufactured by Wako Pure Chemical Industries, Ltd.
Flow rate: 1 mL/min
Column temperature: room temperature
Molecular weight standards: standard polystyrenes

### (Charge Transport Polymer 2B)

A three-neck round-bottom flask was charged with the monomer B1-1 shown above (2.0 mmol), a monomer L-1 shown below (5.0 mmol), the monomer T-1 shown above (1.0 mmol), a monomer T1 shown below (3.0 mmol) and anisole (20 mL), and the prepared Pd catalyst solution (7.5 mL) was then added. Thereafter, synthesis of a charge transport polymer 2B was performed in the same manner as the synthesis of the charge transport polymer 1B.

The obtained charge transport polymer 2B had a number average molecular of 18,400 and a weight average molecular weight of 47,000.

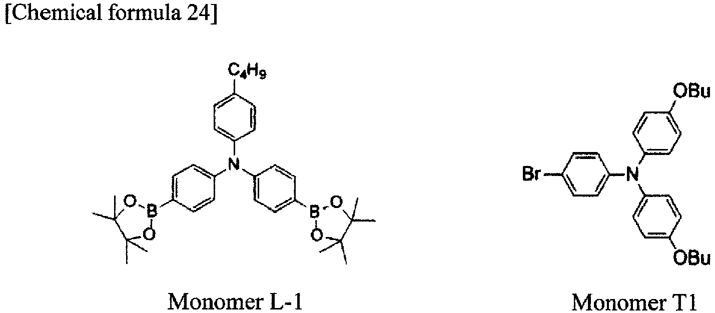

### (Charge Transport Polymer 3B)

A three-neck round-bottom flask was charged with the monomer B1-1 shown above (2.0 mmol), the monomer L1 shown above (5.0 mmol), the monomer T-1 shown above (1.0 mmol), the monomer T1 shown above (3.0 mmol) and anisole (20 mL), and the prepared Pd catalyst solution (7.5 mL) was then added. Thereafter, synthesis of a charge transport polymer 3B was performed in the same manner as the synthesis of the charge transport polymer 1B.

The obtained charge transport polymer 3B had a number average molecular of 23,600 and a weight average molecular weight of 61,200.

### (Charge Transport Polymer 4B)

A three-neck round-bottom flask was charged with a monomer B1-2 shown below (2.0 mmol), the monomer L1 shown above (5.0 mmol), the monomer T-1 shown above (1.0 mmol), the monomer T-2 shown above (3.0 mmol) and anisole (20 mL), and the prepared Pd catalyst solution (7.5 mL) was then added. Thereafter, synthesis of a charge transport polymer 4B was performed in the same manner as the synthesis of the charge transport polymer 1B.

The obtained charge transport polymer 4B had a number average molecular of 20,200 and a weight average molecular weight of 79,800.

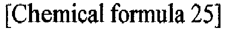

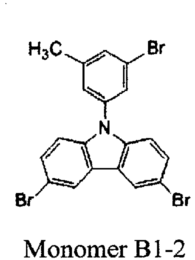

### (Charge Transport Polymer 5B)

A three-neck round-bottom flask was charged with the monomer B1-2 shown above (2.0 mmol), the monomer L-1 shown above (5.0 mmol), the monomer T-1 shown above (1.0 mmol), the monomer T1 shown above (3.0 mmol) and anisole (20 mL), and the prepared Pd catalyst solution (7.5 mL) was then added. Thereafter, synthesis of a charge transport polymer 5B was performed in the same manner as the synthesis of the charge transport polymer 1B.

The obtained charge transport polymer 5B had a number average molecular of 18,400 and a weight average molecular weight of 52,700.

### (Charge Transport Polymer 6B)

A three-neck round-bottom flask was charged with the monomer B1-2 shown above (2.0 mmol), the monomer L1 shown above (5.0 mmol), the monomer T-1 shown above (1.0 mmol), the monomer T1 shown above (3.0 mmol) and anisole (20 mL), and the prepared Pd catalyst solution (7.5 mL) was then added. Thereafter, synthesis of a charge transport polymer 6B was performed in the same manner as the synthesis of the charge transport polymer 1B.

The obtained charge transport polymer 6B had a number average molecular of 25,100 and a weight average molecular weight of 84,300.

### (Charge Transport Polymer 7B)

A three-neck round-bottom flask was charged with the monomer B1-1 shown above (2.0 mmol), the monomer L-1 shown above (5.0 mmol), the monomer T-1 shown above (1.0 mmol), the monomer T-2 shown above (3.0 mmol) and anisole (20 mL), and the prepared Pd catalyst solution (7.5 mL) was then added. Thereafter, synthesis of a charge transport polymer 7B was performed in the same manner as the synthesis of the charge transport polymer 1B.

The obtained charge transport polymer 7B had a number average molecular of 30,900 and a weight average molecular weight of 88,800.

### (Charge Transport Polymer 8B)

A three-neck round-bottom flask was charged with the monomer B1-2 shown above (2.0 mmol), the monomer L-1 shown above (5.0 mmol), the monomer T-1 shown above (1.0 mmol), the monomer T-2 shown above (3.0 mmol) and anisole (20 mL), and the prepared Pd catalyst solution (7.5 mL) was then added. Thereafter, synthesis of a charge transport polymer 8B was performed in the same manner as the synthesis of the charge transport polymer 1B.

The obtained charge transport polymer 8B had a number average molecular of 19,900 and a weight average molecular weight of 65,000.

### (Charge Transport Polymer 9B)

A three-neck round-bottom flask was charged with a monomer B-1 shown below (2.0 mmol), the monomer L-1 shown above (5.0 mmol), a monomer T-3 shown below (1.0 mmol), the monomer T-2 shown above (3.0 mmol) and anisole (20 mL), and the prepared Pd catalyst solution (7.5 mL) was then added. Thereafter, synthesis of a charge transport polymer 9B was performed in the same manner as the synthesis of the charge transport polymer 1B.

The obtained charge transport polymer 9B had a number average molecular of 39,200 and a weight average molecular weight of 75,200.

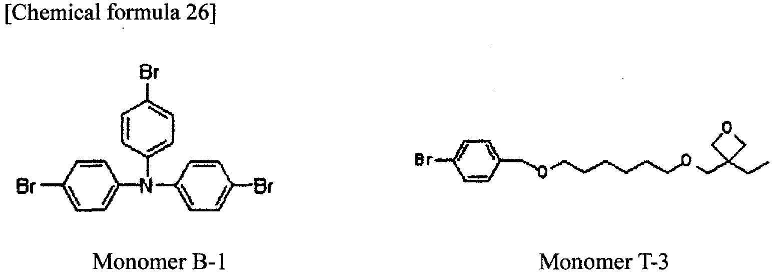

The monomers used in synthesizing the charge transport polymers 1B to 9B are summarized in the table below.

**[Table B1]**

| | Monomers used | | | |
|---|---|---|---|---|
| Charge transport polymer | Structural unit B | Structural unit L | Structural unit T | |
| 1B | B1-1 ⁽¹⁾ | L1 ⁽²⁾ | T-1 | T-2 |
| 2B | B1-1 ⁽¹⁾ | L-1 | T-1 | T1 ⁽²⁾ |
| 3B | B1-1 ⁽¹⁾ | L1 ⁽²⁾ | T-1 | T1 ⁽²⁾ |
| 4B | B1-2 ⁽¹⁾ | L1 ⁽²⁾ | T-1 | T-2 |
| 5B | B1-2 ⁽¹⁾ | L-1 | T-1 | T1 ⁽²⁾ |
| 6B | B1-2 ⁽¹⁾ | L1 ⁽²⁾ | T-1 | T1 ⁽²⁾ |
| 7B | B1-1 ⁽¹⁾ | L-1 | T-1 | T-2 |
| 8B | B1-2 ⁽¹⁾ | L-1 | T-1 | T-2 |
| 9B | B-1 | L-1 | T-3 | T-2 |

| | | | | |
|---|---|---|---|---|
| Notes: The superscript (1) indicates a monomer corresponding with a trivalent or higher valent structural unit having a 9-phenylcarbazole structure. The superscript (2) indicates a monomer corresponding with a structural unit having a triphenylamine structure in which at least one phenyl group has an alkoxy group. | | | | |

### <II> Production and Evaluation of Hole-Only Devices (Evaluation of Heat Resistance of Charge Transport Polymers)

Using each of the prepared charge transport polymers, a hole-only device was produced in the manner described below, and the heat resistance was then evaluated based on the current density characteristics of the hole-only device.

### (Example 1B)

Under a nitrogen atmosphere, the charge transport polymer 1B (50.0 mg), a dopant 1 shown above (2.5 mg) and toluene (1.36 mL) were mixed together to prepare an ink composition. The ink composition was spin-coated at a rotational rate of 3,000 min⁻¹ onto a glass substrate on which ITO had been patterned with a width of 1.6 mm, and the coating film was then cured by heating at 180°C for 10 minutes on a hotplate, thus forming a hole injection layer (150 nm).

The glass substrate having the above hole injection layer was then transferred into a vacuum deposition apparatus, and A1 (150 nm) was deposited by a deposition method on top of the hole injection layer. An encapsulation treatment was then performed to complete production of a hole-only device.

### (Example 2B)

With the exception of altering the hotplate heating conditions to 230°C for 30 minutes in the formation step for the hole injection layer in the hole-only device of Example 1B, a hole-only device was produced in the same manner as Example 1B.

### (Example 3B)

With the exception of replacing the charge transport polymer 1B with the charge transport polymer 2B in the formation step for the hole injection layer in the hole-only device of Example 1B, a hole-only device was produced in the same manner as Example 1B.

### (Example 4B)

With the exception of altering the hotplate heating conditions to 230°C for 30 minutes in the formation step for the hole injection layer in the hole-only device of Example 3B, a hole-only device was produced in the same manner as Example 3B.

### (Comparative Example 1B)

With the exception of replacing the charge transport polymer 1B with the charge transport polymer 9B in the formation step for the hole injection layer in the hole-only device of Example 1B, a hole-only device was produced in the same manner as Example 1B.

### (Comparative Example 2B)

With the exception of altering the hotplate heating conditions to 230°C for 30 minutes in the formation step for the hole injection layer in the hole-only device of Comparative Example 1B, a hole-only device was produced in the same manner as Comparative Example 1B.

### (Comparative Example 3B)

With the exception of replacing the charge transport polymer 1B with the charge transport polymer 8B in the formation step for the hole injection layer in the hole-only device of Example 1B, a hole-only device was produced in the same manner as Example 1B.

### (Comparative Example 4B)

With the exception of altering the hotplate heating conditions to 230°C for 30 minutes in the formation step for the hole injection layer in the hole-only device of Comparative Example 3B, a hole-only device was produced in the same manner as Comparative Example 3B.

The materials and heating conditions used for forming the hole injection layer of the hole-only device in each of the above Examples 1B to 4B and Comparative Examples 1B to 4B are summarized in Table B2.

**[Table B2]**

| | Materials used for hole injection layer formation | Heating conditions |
|---|---|---|
| Example 1B | Charge transport polymer 1B Dopant 1 | 180°C, 10 minutes |
| Example 2B | Charge transport polymer 1B Dopant 1 | 230°C, 30 minutes |
| Example 3B | Charge transport polymer 2B Dopant 1 | 180°C, 10 minutes |
| Example 4B | Charge transport polymer 2B Dopant 1 | 230°C, 30 minutes |
| Comparative Example 1B | Charge transport polymer 9B Dopant 1 | 180°C, 10 minutes |
| Comparative Example 2B | Charge transport polymer 9B Dopant 1 | 230°C, 30 minutes |
| Comparative Example 3B | Charge transport polymer 8B Dopant 1 | 180°C, 30 minutes |
| Comparative Example 4B | Charge transport polymer 8B Dopant 1 | 230°C, 10 minutes |

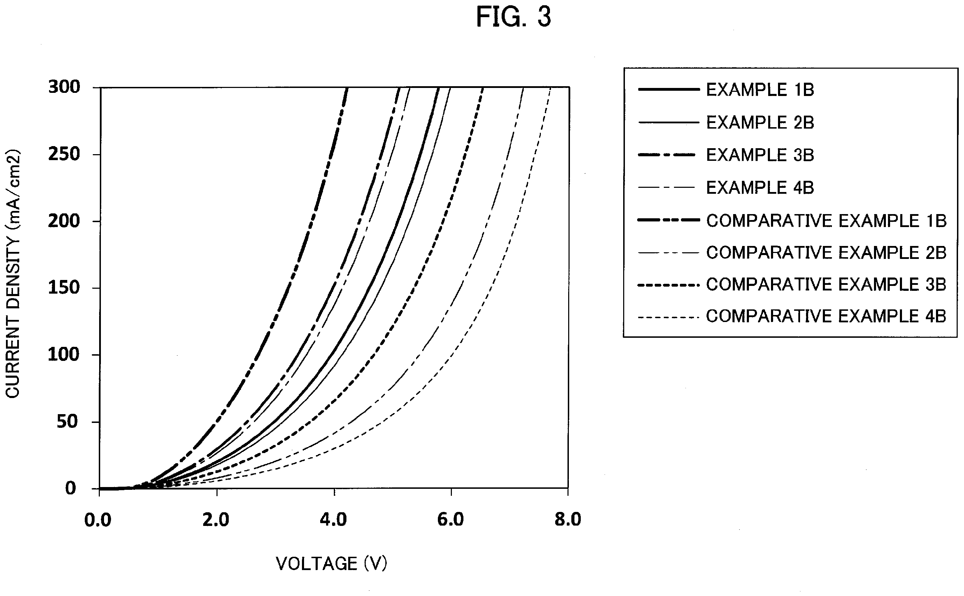

A graph of the voltage-current density curve when a voltage was applied to each of the hole-only devices obtained in Examples 1B to 4B and Comparative Examples 1B to 4B is shown in FIG. 3.

Examples 2B and 4B and Comparative Examples 2B and 4B used the same materials as Examples 1B and 3B and Comparative Examples 1B and 3B respectively, but the heating conditions during formation of the hole injection layer were more severe (namely, at a higher temperature for a longer heating time). As is evident from the graph shown in FIG. 3, based on the proportional increase in the drive voltage of Examples 2B and 4B and Comparative Examples 2B and 4B compared with Examples 1B and 3B and Comparative Examples 1B and 3B respectively, it was clear that the drive voltage increased dramatically in Comparative Example 2B which did not include a 9-phenylcarbazole structural unit. On the other hand, the proportional increase in the drive voltage in Examples 2B and 4B and Comparative Example 4B, which did include a 9-phenylcarbazole structural unit, was clearly lower than that in Comparative Example 2B. Here, the drive voltage means the voltage required to obtain a constant current density. In particular, the increase in drive voltage in Examples 2B and 4B which used more severe heating conditions during formation of the hole injection layer than Examples 1B and 3B respectively was minor.

Generally, if the heat resistance of the polymer is low, then heat history tends to cause degradation of the organic thin film and an increase in the drive voltage of the organic EL element. In this regard, as is evident from a comparison of Examples 1B to 4B and Comparative Examples 1B to 4B, it is clear that polymers having both a 9-phenylcarbazole structural unit and a triphenylamine structural unit in which at least one phenyl group has an alkoxy group exhibit superior heat resistance to polymers not having these specific structures. This type of improvement in the heat resistance makes it easier to stably maintain the drive voltage.

### <III> Production and Evaluation of Organic EL Elements

### <III-1>

The following examples and comparative examples relate to embodiments in which an organic thin film formed using an organic electronic material (ink composition) containing a charge transport polymer is used as a hole injection layer.

### (Example 5B)

Under a nitrogen atmosphere, the charge transport polymer 1B (10.0 mg), a dopant 1 shown below (0.5 mg) and toluene (2.3 mL) were mixed together to prepare an ink composition. The ink composition was spin-coated at a rotational rate of 3,000 min⁻¹ onto a glass substrate on which ITO had been patterned with a width of 1.6 mm, and the coating film was then cured by heating at 230°C for 30 minutes on a hotplate, thus forming a hole injection layer (30 nm).

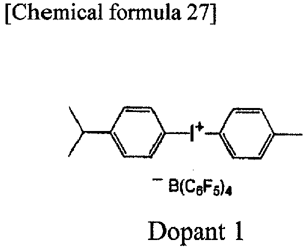

The glass substrate was transferred into a vacuum deposition apparatus, and layers of α-NPD (40 nm), CBP:Ir(ppy)₃ (94:6, 30 nm), BAlq (10 nm), TPBi (30 nm), Liq (2.0 nm) and Al (150 nm) were deposited in that order using deposition methods on top of the hole injection layer. An encapsulation treatment was then performed to complete production of an organic EL element.

### (Example 6B)

With the exception of replacing the charge transport polymer 1B with the charge transport polymer 2B in the formation step for the hole injection layer in the organic EL element of Example 5B, an organic EL element was produced in the same manner as Example 5B.

### (Example 7B)

With the exception of replacing the charge transport polymer 1B with the charge transport polymer 3B in the formation step for the hole injection layer in the organic EL element of Example 5B, an organic EL element was produced in the same manner as Example 5B.

### (Comparative Example 5B)

With the exception of replacing the charge transport polymer 1B with the charge transport polymer 7B in the formation step for the hole injection layer in the organic EL element of Example 5B, an organic EL element was produced in the same manner as Example 5B.

### (Comparative Example 6B)

With the exception of replacing the charge transport polymer 1B with the charge transport polymer 8B in the formation step for the hole injection layer in the organic EL element of Example 5B, an organic EL element was produced in the same manner as Example 5B.

### (Comparative Example 7B)

With the exception of replacing the charge transport polymer 1B with the charge transport polymer 9B in the formation step for the hole injection layer in the organic EL element of Example 5B, an organic EL element was produced in the same manner as Example 5B.

The materials used for forming the hole injection layer of the organic EL element in the above Examples 5B to 7B and Comparative Examples 5B to 7B are summarized in Table B3.

**[Table B3]**

| | Materials used for hole injection layer formation |
|---|---|
| Example 5B | Charge transport polymer 1B, Dopant 1 |
| Example 6B | Charge transport polymer 2B, Dopant 1 |
| Example 7B | Charge transport polymer 3B, Dopant 1 |
| Comparative Example 5B | Charge transport polymer 7B, Dopant 1 |
| Comparative Example 6B | Charge transport polymer 8B, Dopant 1 |
| Comparative Example 7B | Charge transport polymer 9B, Dopant 1 |

When a voltage was applied to the organic EL elements obtained in Examples 5B to 7B and Comparative Examples 5B to 7B, green light emission was confirmed in each case. For each element, the emission efficiency at a luminance of 5,000 cd/m² and the emission lifespan (luminance half-life) when the initial luminance was 5,000 cd/m² were measured. The measurement results are shown in Table B4. Measurement of the luminance was performed using an SR-3AR device manufactured by Topcon Technohouse Corporation.

**[Table B4]**

| | Emission efficiency (cd/A) | Emission lifespan (h) |
|---|---|---|
| Example 5B | 31.9 | 388.1 |
| Example 6B | 30.4 | 387.2 |
| Example 7B | 32.7 | 405.8 |
| Comparative Example 5B | 25.2 | 299.2 |
| Comparative Example 6B | 25.8 | 301.4 |
| Comparative Example 7B | 28.4 | 258.9 |

As illustrated in Table B4, in Examples 5B to 7B, organic EL elements were obtained which, compared with those of Comparative examples 5B to 7B, had superior emission efficiency and a longer lifespan. Based on these results, it is evident that by using an organic electronic material containing a specific charge transport polymer that satisfies the requirements of the present invention, effects including an improvement in the emission efficiency and an improvement in the lifespan can be achieved.

### <III-2>

The following examples and comparative examples relate to embodiments in which an organic thin film formed using an organic electronic material (ink composition) containing a charge transport polymer is used as a hole transport layer.

### (Example 8B)

Under a nitrogen atmosphere, the charge transport polymer 7B (10.0 mg), the dopant 1 shown above (0.5 mg) and toluene (2.3 mL) were mixed together to prepare an ink composition. The ink composition was spin-coated at a rotational rate of 3,000 min⁻¹ onto a glass substrate on which ITO had been patterned with a width of 1.6 mm, and was then cured by heating at 220°C for 10 minutes on a hotplate, thus forming a hole injection layer (30 nm).

Next, the charge transport polymer 4B (20.0 mg), a dopant 2 shown below (0.5 mg) and toluene (2.3 mL) were mixed together to prepare another ink composition. This ink composition was spin-coated at a rotational rate of 3,000 min⁻¹ onto the hole injection layer, and the coating film was then cured by heating at 200°C for 10 minutes on a hotplate, thus forming a hole transport layer (40 nm). The hole transport layer was able to be formed without dissolving the hole injection layer.

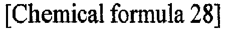

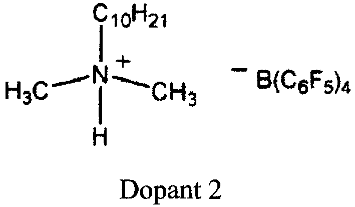

The glass substrate was transferred into a vacuum deposition apparatus, and layers of CBP:Ir(ppy)₃ (94:6, 30 nm), BAlq (10 nm), TPBi (30 nm), Liq (2.0 nm) and Al (150 nm) were deposited in that order using deposition methods on top of the hole transport layer. An encapsulation treatment was then performed to complete production of an organic EL element.

### (Example 9B)

With the exception of replacing the charge transport polymer 4B with the charge transport polymer 5B in the formation step for the hole transport layer in the organic EL element of Example 8B, an organic EL element was produced in the same manner as Example 8B.

### (Example 10B)

With the exception of replacing the charge transport polymer 4B with the charge transport polymer 6B in the formation step for the hole transport layer in the organic EL element of Example 8B, an organic EL element was produced in the same manner as Example 8B.

### (Example 11B)

With the exception of replacing the charge transport polymer 7B with the charge transport polymer 3B in the formation step for the hole injection layer in the organic EL element of Example 10B, an organic EL element was produced in the same manner as Example 10B.

### (Comparative Example 8B)

With the exception of replacing the charge transport polymer 4B with the charge transport polymer 8B in the formation step for the hole transport layer in the organic EL element of Example 8B, an organic EL element was produced in the same manner as Example 8B.

### (Comparative Example 9B)

With the exceptions of replacing the charge transport polymer 7B with the charge transport polymer 9B in the formation step for the hole injection layer in the organic EL element of Example 8B, and replacing the charge transport polymer 4B with the charge transport polymer 7B in the formation step for the hole transport layer, an organic EL element was produced in the same manner as Example 8B.

The materials used for forming the hole injection layer and the hole transport layer of the organic EL element in the above Examples 8B to 11B and Comparative Examples 8B and 9B are summarized in Table B5.

**[Table B5]**

| | Materials used for hole injection layer formation | Materials used for hole transport layer formation |
|---|---|---|
| Example 8B | Charge transport polymer 7B Dopant 1 | Charge transport polymer 4B Dopant 2 |
| Example 9B | Charge transport polymer 7B Dopant 1 | Charge transport polymer 5B Dopant 2 |
| Example 10B | Charge transport polymer 7B Dopant 1 | Charge transport polymer 6B Dopant 2 |
| Example 11B | Charge transport polymer 3B Dopant 1 | Charge transport polymer 6B Dopant 2 |
| Comparative Example 8B | Charge transport polymer 7B Dopant 1 | Charge transport polymer 8B Dopant 2 |
| Comparative Example 9B | Charge transport polymer 9B Dopant 1 | Charge transport polymer 7B Dopant 2 |

When a voltage was applied to the organic EL elements obtained in Examples 8B to 11B and Comparative Example 8B and 9B, green light emission was confirmed in each case. For each element, the emission efficiency at a luminance of 5,000 cd/m² and the emission lifespan (luminance half-life) when the initial luminance was 5,000 cd/m² were measured. The measurement results are shown in Table B6. Measurement of the luminance was performed using an SR-3AR device manufactured by Topcon Technohouse Corporation.

**[Table B6]**

| | Emission efficiency (cd/A) | Emission lifespan (h) |
|---|---|---|
| Example 8B | 36.0 | 101.7 |
| Example 9B | 35.8 | 99.9 |
| Example 10B | 35.3 | 95.2 |
| Example 11B | 37.1 | 115.9 |
| Comparative Example 8B | 29.0 | 65.8 |
| Comparative Example 9B | 31.1 | 32.4 |

As illustrated in Table B6, in Examples 8B to 11B, organic EL elements were obtained which, compared with those of Comparative examples 8B and 9B, had superior emission efficiency and a longer lifespan. Based on these results, it is evident that by using an organic electronic material containing a specific charge transport polymer that satisfies the requirements of the present invention, effects including an improvement in the emission efficiency and an improvement in the lifespan can be achieved.

### <IV> Production and Evaluation of White Organic EL Elements (Illumination Devices)

### (Example 12B)

Under a nitrogen atmosphere, the charge transport polymer 3B (10.0 mg), the dopant 1 shown above (0.5 mg) and toluene (2.3 mL) were mixed together to prepare an ink composition. The ink composition was spin-coated at a rotational rate of 3,000 min⁻¹ onto a glass substrate on which ITO had been patterned with a width of 1.6 mm, and the coating film was then cured by heating at 220°C for 10 minutes on a hotplate, thus forming a hole injection layer (30 nm).

Next, the charge transport polymer 6B (20.0 mg), the dopant 2 shown above (0.5 mg) and toluene (2.3 mL) were mixed together to prepare another ink composition. This ink composition was spin-coated at a rotational rate of 3,000 min⁻¹ onto the hole injection layer, and was then cured by heating at 230°C for 30 minutes on a hotplate, thus forming a hole transport layer (40 nm). The hole transport layer was able to be formed without dissolving the hole injection layer.

Subsequently, under a nitrogen atmosphere, CDBP (15 mg), FIr(pic) (0.9 mg), Ir(ppy)₃ (0.9 mg), btp₂Ir(acac) (1.2 mg) and dichlorobenzene (0.5 mL) were mixed together to prepare another ink composition. This ink composition was spin-coated at a rotational rate of 3,000 min⁻¹, and was then dried by heating at 80°C for 5 minutes, thus forming a light-emitting layer (40 nm). The light-emitting layer was able to be formed without dissolving the hole transport layer.

The glass substrate was then transferred into a vacuum deposition apparatus, and layers of BAlq (10 nm), TPBi (30 nm), Liq (2.0 nm) and Al (150 nm) were deposited in that order using deposition methods on top of the light-emitting layer. An encapsulation treatment was then performed to complete production of a white organic EL element. The white organic EL element was able to be used as an illumination device.

### [Comparative Example 10B]

With the exceptions of replacing the charge transport polymer 3B with the charge transport polymer 7B in the formation step for the hole injection layer in the organic EL element of Example 12B, and replacing the charge transport polymer 6B with the charge transport polymer 8B in the formation step for the hole transport layer, a white organic EL element was produced in the same manner as Example 12B.

A voltage was applied to the white organic EL elements obtained in Example 12B and Comparative Example 10B, and the voltage at a luminance of 1,000 cd/m², and the emission lifespan (luminance half-life) when the initial luminance was 1,000 cd/m² were measured. When the voltage for Example 12B was deemed to be 1.0, the voltage for Comparative Example 10B was 1.09. Further, when the emission lifespan for Example 12B was deemed to be 1.0, the emission lifespan for Comparative Example 10B was 0.33. In this manner, the white organic EL element of Example 12B had excellent drive voltage and emission lifespan.

By using an organic electronic material containing a charge transport polymer according to an embodiment of the present invention, an organic layer can be formed easily using a wet process. Further, as a result of the improvement in the heat resistance of the charge transport polymer, the drive voltage can be stably maintained, and an organic EL element having excellent levels of various element characteristics such as the lifespan characteristics can be easily obtained.

The effects of embodiments of the present invention have been illustrated above using a series of examples. However, the present invention is not limited to the charge transport polymers used in the above examples, and provided the materials do not depart from the scope of the present invention, superior organic electronic elements can be obtained in a similar manner using other charge transport polymers.

## Claims

1. An organic electronic material comprising a charge transport polymer that includes a 9-phenylcarbazole moiety, and also includes a structure branched in at least three directions from the 9-phenylcarbazole moiety, wherein the organic electronic material satisfies at least one of (I) or (II) shown below:
(I) the 9-phenylcarbazole moiety has a hydrogen atom at position 4 of a phenyl group of the 9-phenylcarbazole moiety,
(II) the charge transport polymer also has a triphenylamine structure in which at least one phenyl group has an alkoxy group.

2. The organic electronic material according to Claim 1, further comprising a dopant.

3. The organic electronic material according to Claim 2, wherein the dopant comprises an onium salt.

4. The organic electronic material according to any one of Claims 1 to 3, wherein the charge transport polymer has a polymerizable functional group.

5. An organic layer formed using the organic electronic material according to any one of Claims 1 to 4.

6. An organic electronic element comprising the organic layer according to Claim 5.

7. An organic electroluminescent element comprising the organic layer according to Claim 5.

8. The organic electroluminescent element according to Claim 7, wherein the organic layer is a hole injection layer.

9. The organic electroluminescent element according to Claim 7, wherein the organic layer is a hole transport layer.

10. The organic electroluminescent element according to any one of Claims 7 to 9, also having a flexible substrate.

11. The organic electroluminescent element according to any one of Claims 7 to 9, also having a resin film substrate.

12. A display element comprising the organic electroluminescent element according to any one of Claims 7 to 11.

13. An illumination device comprising the organic electroluminescent element according to any one of Claims 7 to 11.

14. A display device comprising the illumination device according to Claim 13, and a liquid crystal element as a display unit.
